(19) Europäisches Patentamt

European Patent Office

Office européen des brevets

(11) **EP 4 478 325 B1**

(12) **EUROPEAN PATENT SPECIFICATION**

(45) Date of publication and mention
of the grant of the patent:
**25.03.2026 Bulletin 2026/13**

(21) Application number: **23382594.2**

(22) Date of filing: **15.06.2023**

(51) International Patent Classification (IPC):
**G08G 1/01** (2006.01)

(52) Cooperative Patent Classification (CPC):
**G08G 1/0129; G08G 1/0116**

(54) **EMISSIONS ESTIMATION AND REGION CATEGORIZATION**

EMISSIONSSCHÄTZUNG UND REGIONSKATEGORISIERUNG

ESTIMATION D'ÉMISSIONS ET CATÉGORISATION DE RÉGIONS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**18.12.2024 Bulletin 2024/51**

(73) Proprietor: **FUJITSU LIMITED
Kawasaki-shi, Kanagawa 211-8588 (JP)**

(72) Inventors:
• **PEÑA MUÑOZ, Manuel
28400 Madrid (ES)**
• **MAKARIOU, Savvas
London, W9 1UE (GB)**

(74) Representative: **Haseltine Lake Kempner LLP
Cheapside House
138 Cheapside
London EC2V 6BJ (GB)**

(56) References cited:
• **WENDY WEIJERMARS: "Analysis of urban traffic
patterns using clustering", 13 April 2007
(2007-04-13), XP055694323, Retrieved from the
Internet <URL:https://ris.utwente.nl/ws/
portalfiles/portal/6069766/thesis_Weijermars.
pdf> [retrieved on 20231115]**
• **HICKS J. ET AL: "Improving the resolution of
gridded-hourly mobile emissions: incorporating
spatial variability and handling missing data",
TRANSPORTATION RESEARCH. PART D,
TRANSPORT AND ENVIRONMENT, 1 May 2001
(2001-05-01), pages 153 - 177, XP093102583,
Retrieved from the Internet <URL:https://www.
sciencedirect.com/science/article/pii/
S1361920900000201> [retrieved on 20231116],
DOI: 10.1016/S1361-9209(00)00020-1**
• **WEI-CHIANG HONG: "Application of seasonal
SVR with chaotic immune algorithm in traffic
flow forecasting", NEURAL COMPUTING AND
APPLICATIONS, SPRINGER-VERLAG, LO, vol.
21, no. 3, 16 October 2010 (2010-10-16), pages
583 - 593, XP035028198, ISSN: 1433-3058, DOI:
10.1007/S00521-010-0456-7**

**Description**

The present invention relates to emissions estimation, and in particular to a computer-implemented method, a computer program, and an information programming apparatus.

There exists a trend where the real world may be represented as a digital world. Concepts such as Smart Cities, Digital Twins (DTs) and Metaverse have received more attention, at least in part due to the new/improved technologies that enable new steps in these concepts, such as: data, security, Internet of Things (IoT), 5th Generation technology standard for telecommunications (5G), Artificial Intelligence (AI), and Quantum Computing, among others.

$CO_2$ emissions from transportation modes, i.e., the release of carbon dioxide into the atmosphere as a result of human transportation activities, contribute significantly to the overall greenhouse gas emissions that drive climate change. According to the International Energy Agency, transportation accounted for approximately 24% of global energy-related $CO_2$ emissions in 2019. Traffic forecasting, the process of predicting future traffic conditions in short-term or near-term future, based on current and past traffic observations is important in understanding and dealing with traffic in order to reduce $CO_2$ emissions from transportation modes. Short-term traffic flow forecasting, which involves the prediction of traffic volume in the next time interval, usually in the range of five minutes to 1 hour, is one of the important research problems in the field of traffic congestion, being addressed by many researchers in the last two decades (e.g., Kumar, S.V., Vanajakshi, L. Short-term traffic flow prediction using seasonal ARIMA model with limited input data. Eur. Transp. Res. Rev. 7, 21 (2015). https://doi.org/10.1007/s12544-015-0170-8).

In light of the above, improved estimation of emissions is desired.

The present invention is defined by the independent claims, to which reference should now be made. Specific embodiments are defined in the dependent claims.

According to a first aspect according to claim 1, there is disclosed herein a computer-implemented method comprising: based on a plurality of sets of (historical) traffic data of a plurality of geographical regions, respectively, performing a parameter determination process comprising: clustering the sets of traffic data based on similarity to each other to generate a plurality of clusters of the sets of traffic data; for each cluster comprising a plurality of sets of traffic data, selecting as a representative set of traffic data the set of traffic data of the cluster which is most similar to an average of the sets of traffic data of the cluster; and based on a representative set of traffic data corresponding to a target geographical region, performing mobility analysis to determine (optimal) parameters for a seasonal traffic forecast for the target geographical region and, based on at least one representative set of traffic data corresponding to at least one other geographical region, performing mobility analysis to determine (optimal) parameters for at least one other seasonal traffic forecast for the at least one other geographical region; performing a traffic forecasting process for the target geographical region using the set of traffic data of the target geographical region and the at least one set of traffic data for the at least one other geographical region, the traffic forecasting process comprising: based on the set of traffic data of the target geographical region, and using the determined parameters for the seasonal traffic forecast for the target geographical region, generating the seasonal traffic forecast (predicting traffic data in a future time period) for the target geographical region (by estimating a seasonal component of the traffic data of the target geographical region); based on the at least one set of traffic data of the at least one other geographical region, and using the determined parameters for the at least one other seasonal traffic forecast for the at least one other geographical region, generating the at least one other seasonal traffic forecast (predicting traffic data in a future time period) for the at least one other geographical region (by estimating a seasonal component of the traffic data of the at least one other geographical region); based on the set of traffic data of the geographical region and the at least one set of traffic data of the at least one other geographical region, analyzing a mobility flow of the geographical area to determine at least one correlation between (trends in) the traffic data of the target geographical region and the at least one other geographical region; and generating a combined traffic forecast (or a final forecast or cumulative forecast or overall forecast) by adjusting the seasonal forecast for the target geographical region based on the at least one other seasonal forecast and the determined at least one correlation; and predicting emissions produced by traffic in the target geographical region based on the final traffic forecast.

The set of traffic data of the target geographical region and the at least one set of traffic data for the at least one other geographical region may comprise traffic data over a first time period and the final traffic forecast is a first traffic forecast. The computer-implemented method may comprise generating a second traffic forecast by performing the traffic forecasting process using traffic data over a second time period (instead of the traffic data over the first time period), wherein the first time period comprises the second time period and an additional time period more recent than the second time period. The computer-implemented method may comprise: decomposing the first traffic forecast into first seasonal, trend, and noise components and decomposing the second traffic forecast into second seasonal, trend, and noise components; and comparing the first noise component of the first traffic forecast with the second noise component of the second traffic forecast to detect at least one anomaly, comprising comparing at least one deviation between the first and second traffic forecasts to an anomaly threshold (and, if the deviation is greater in magnitude than the anomaly threshold, classifying the deviation as an anomaly). Predicting emissions produced by traffic in the target geographical region may comprise, when at least one anomaly has been detected, predicting the impact on the emissions of the at least one detected anomaly.

Generating the second traffic forecast by performing the traffic forecasting process using the traffic data of the second time period (instead of the traffic data of the first time period) may comprise using the determined parameters for the seasonal traffic forecast for the target geographical region and the determined parameters for the at least one other seasonal traffic forecast for the at least one other geographical region.

Clustering the sets of traffic data based on similarity to each other may comprise clustering the sets of traffic data based on at least one aspect of the traffic data, the at least one aspect comprising any of: a number of vehicles inside the geographical region (over time); a number of each of a plurality of types of vehicles inside the geographical region (over time); a location of each of a plurality of vehicles inside the geographical region (over time); a direction of travel of each of a plurality of vehicles inside the geographical region (over time); a speed of each of a plurality of vehicles inside the geographical region (over time); an average speed of each of a plurality of vehicles inside the geographical region (over time); a minimum and/or maximum speed of each of a plurality of vehicles inside the geographical region (over time); a level of congestion inside the geographical region (over time); a number of traffic jams inside the geographical region; a level of use of a road network inside the geographical region (over time); and a maximum transit capacity (of a road network) inside the geographical region (over time).

Clustering the sets of traffic data based on similarity to each other comprises clustering the sets of traffic data based on at least one aspect of the traffic data, the at least one aspect comprising any of: a number of vehicles inside the geographical region (over time) or a number of each of a plurality of types of vehicles inside the geographical region (over time); and an average speed of each of a plurality of vehicles inside the geographical region (over time).

The parameter determination process may comprise, before the clustering, obtaining a behavioral representation of each set of traffic data, the behavioral representations based on at least one aspect of the data, the at least one aspect comprising any of: a number of vehicles inside the geographical region (over time) or a number of each of a plurality of types of vehicles inside the geographical region (over time); and an average speed of each of a plurality of vehicles inside the geographical region (over time).

Clustering the sets of traffic data based on similarity to each other may comprise clustering the sets of traffic data based on the similarity of the corresponding behavioral representations to each other.

Clustering the sets of traffic data based on similarity to each other may comprise using dynamic time warping matching or Euclidean matching between the sets of traffic data or between the behavioral representations.

The traffic data may comprise vehicular traffic data.

The traffic data comprises data obtained from sensors in (a geographical area comprising) the geographical region(s) concerned.

The traffic data may comprise data obtained from a digital twin of the geographical region concerned.

The traffic data may comprise data obtained from a digital twin of a geographical area comprising the geographical region(s) concerned.

The traffic data may comprise data obtained from sensors in (a geographical area comprising) the geographical region(s) concerned, and data obtained from a digital twin of (a geographical area comprising) the geographical region concerned.

The data obtained from the digital twin may be based on data obtained from sensors in the geographical area/geographical region concerned.

The digital twin may be a model/simulation of the geographical area/region.

The digital twin may be a model/simulation of the geographical area/region with some modifications compared to the real geographical area/region (to model a scenario).

The data obtained from the digital twin based on data obtained from sensors may comprise data that has undergone at least one pre-processing stage optionally comprising generation of intermediate variables and/or values.

The at least one other geographical region may comprise a plurality of geographical regions (and the traffic forecasting process comprises generating a plurality of other seasonal traffic forecasts for the plurality of other geographical regions) (and the parameter determination process comprises determining (optimal) parameters for each of the plurality of other seasonal traffic forecasts for the plurality of other geographical regions).

The target geographical region and the at least one other geographical region may be respective regions of an urban area or a town or city.

The geographical area may comprise an urban area or a town or city.

The traffic data of a said geographical region (first and/or second traffic data and/or traffic data of a said geographical region and/or sets of traffic data of a said geographical region) may comprise any of: a number of vehicles inside the geographical region (over time); a number of each of a plurality of types of vehicles inside the geographical region (over time); a location of each of a plurality of vehicles inside the geographical region (over time); a direction of travel of each of a plurality of vehicles inside the geographical region (over time); a speed of each of a plurality of vehicles inside the geographical region (over time); an average speed of each of a plurality of vehicles inside the geographical region (over time); a minimum and/or maximum speed of each of a plurality of vehicles inside the geographical region (over time); a level of congestion inside the geographical region (over time); a number of traffic jams inside the geographical region; a level of use of a road network inside the geographical region (over time); a maximum transit capacity (of a road network) inside the geographical region (over time) and an identifier of each of a plurality of vehicles inside the geographical region (over time).

The traffic data of a said geographical region (first and/or second traffic data and/or traffic data of a said geographical region and/or sets of traffic data of a said geographical region) comprises: a number of vehicles inside the geographical region (over time) or a number of each of a plurality of types of vehicles inside the geographical region (over time); and an average speed of each of a plurality of vehicles inside the geographical region (over time).

A said traffic forecast may comprise predicted traffic data comprising: a number of vehicles inside the geographical region (over time); a number of each of a plurality of types of vehicles inside the geographical region (over time); a location of each of a plurality of vehicles inside the geographical region (over time); a direction of travel of each of a plurality of vehicles inside the geographical region (over time); a speed of each of a plurality of vehicles inside the geographical region (over time); an average speed of each of a plurality of vehicles inside the geographical region (over time); a minimum and/or maximum speed of each of a plurality of vehicles inside the geographical region (over time); a level of congestion inside the geographical region (over time); a number of traffic jams inside the geographical region; a level of use of a road network inside the geographical region (over time); a maximum transit capacity (of a road network) inside the geographical region (over time) and an identifier of each of a plurality of vehicles inside the geographical region (over time).

A said traffic forecast may comprise predicted traffic data comprising: a number of vehicles inside the geographical region (over time) or a number of each of a plurality of types of vehicles inside the geographical region (over time); and an average speed of each of a plurality of vehicles inside the geographical region (over time).

The sensors may comprise any of: at least one on-board vehicle sensor; at least one user equipment; at least one camera; and at least one speed sensor.

The computer-implemented method comprises based on the traffic data of the target geographical region, performing mobility analysis to determine (optimal) parameters for the seasonal traffic forecast for the target geographical region; and based on traffic data of the at least one other geographical region, performing mobility analysis to determine (optimal) parameters for the at least one other seasonal traffic forecast for the at least one other geographical region. The traffic forecasting process may comprise using the determined parameters for the seasonal traffic forecast for the target geographical region to generate the seasonal traffic forecast for the target geographical region and using the determined parameters for the at least one other seasonal traffic forecast for the at least one other geographical region to generate the at least one other seasonal traffic forecast for the at least one other geographical region.

Performing the mobility analysis may comprise identifying trends in the traffic data concerned.

Performing the mobility analysis comprises: obtaining levels of stationarity of a yearly trend (including determining an order of seasonal differencing (using a Canova-Hansen process)); and/or obtaining relations among the data of different time periods (using any of a Kwiatkowski-Phillips-Schmidt-Shin technique, an augmented Dickey-Fuller technique, or a Phillips-Perron technique); and/or obtaining a range of values in which a mobility trend oscillates (using an autocorrelation function technique, a partial autocorrelation function technique, and/or an extended autocorrelation function technique).

Performing the mobility analysis comprises: obtaining levels of stationarity of a yearly trend and determining stationary parameters (including determining an order of seasonal differencing (using a Canova-Hansen process)); and/or obtaining relations among the data of different time periods and determining regression parameters (using any of a Kwiatkowski-Phillips-Schmidt-Shin technique, an augmented Dickey-Fuller technique, or a Phillips-Perron technique); and/or obtaining a range of values in which a mobility trend oscillates and determining predictor parameters (using an autocorrelation function technique, a partial autocorrelation function technique, and/or an extended autocorrelation function technique).

Generating the seasonal traffic forecast of the target geographical region (or of a said geographical region) may comprise generating, based on the traffic data concerned, regressors that define a seasonal aspect of the data (optionally using Fourier transforms or sinusoidal decomposition, optionally wherein the regressors are generated as Fourier factors).

Generating the seasonal traffic forecast of the target geographical region (or of a said geographical region) may comprise generating the seasonal traffic forecast based on the regressors concerned, the traffic data concerned, and the parameters concerned.

The computer-implemented method/traffic forecasting process may comprise analyzing the mobility flow of the target geographical region and a plurality of other geographical regions to determine the at least one other geographical region relevant for the traffic forecast of the target geographical region.

The traffic data may comprise information about events occurring in the geographical region concerned. The computer-implemented method/traffic forecasting process may comprise analyzing the traffic data of the target region to obtain at least one correlation between traffic data and at least one (external) event. Generating a (the first) traffic forecast by adjusting the seasonal forecast for the target geographical region based on the at least one other seasonal forecast and the determined correlation further may comprise adjusting the seasonal forecast for the target geographical region based on the at least one correlation between traffic data and at least one external event and based on a predicted at least one event.

The at least one event may comprise any of a weather event, a traffic event, an accident event, and an entertainment event.

Decomposing the first traffic forecast into first seasonal, trend, and noise components and decomposing the second traffic forecast into second seasonal, trend, and noise components may comprise using a Seasonal Trend Decomposition with LOESS, STL, technique.

Comparing at least one deviation between the first and second noise components to an anomaly threshold may comprise comparing a percentage deviation to the anomaly threshold.

The percentage deviation may be the deviation as a percentage of the value of the first or second noise component (at the point in time concerned).

Decomposing the first and second traffic forecasts into the components may comprise decomposing at least one aspect of the first and second traffic forecasts, the at least one aspect comprising any of: a number of vehicles inside the geographical region (over time); a number of each of a plurality of types of vehicles inside the geographical region (over time); a location of each of a plurality of vehicles inside the geographical region (over time); a direction of travel of each of a plurality of vehicles inside the geographical region (over time); a speed of each of a plurality of vehicles inside the geographical region (over time); an average speed of each of a plurality of vehicles inside the geographical region (over time); a minimum and/or maximum speed of each of a plurality of vehicles inside the geographical region (over time); a level of congestion inside the geographical region (over time); a number of traffic jams inside the geographical region; a level of use of a road network inside the geographical region (over time); a maximum transit capacity (of a road network) inside the geographical region (over time) and an identifier of each of a plurality of vehicles inside the geographical region (over time).

Decomposing the first and second traffic forecasts into the components may comprise decomposing at least one aspect of the first and second traffic forecasts, the at least one aspect comprising any of: a number of vehicles inside the geographical region (over time) or a number of each of a plurality of types of vehicles inside the geographical region (over time); and an average speed of each of a plurality of vehicles inside the geographical region (over time).

Estimating the emissions comprises computing an emissions amount based on: information indicating average emissions of a vehicle based on the speed; the number of vehicles from the traffic forecast; and the average speed of vehicles from the traffic forecast.

According to a second aspect according to claim 11, there is disclosed herein a computer program which, when run on a computer, causes the computer to carry out a method comprising: based on a plurality of sets of (historical) traffic data of a plurality of geographical regions, respectively, performing a parameter determination process comprising: clustering the sets of traffic data based on similarity to each other to generate a plurality of clusters of the sets of traffic data; for each cluster comprising a plurality of sets of traffic data, selecting as a representative set of traffic data the set of traffic data of the cluster which is most similar to an average of the sets of traffic data of the cluster; and based on a representative set of traffic data corresponding to a target geographical region, performing mobility analysis to determine (optimal) parameters for a seasonal traffic forecast for the target geographical region and, based on at least one representative set of traffic data corresponding to at least one other geographical region, performing mobility analysis to determine (optimal) parameters for at least one other seasonal traffic forecast for the at least one other geographical region; performing a traffic forecasting process for the target geographical region using the set of traffic data of the target geographical region and the at least one set of traffic data for the at least one other geographical region, the traffic forecasting process comprising: based on the set of traffic data of the target geographical region, and using the determined parameters for the seasonal traffic forecast for the target geographical region, generating the seasonal traffic forecast (predicting traffic data in a future time period) for the target geographical region (by estimating a seasonal component of the traffic data of the target geographical region); based on the at least one set of traffic data of the at least one other geographical region, and using the determined parameters for the at least one other seasonal traffic forecast for the at least one other geographical region, generating the at least one other seasonal traffic forecast (predicting traffic data in a future time period) for the at least one other geographical region (by estimating a seasonal component of the traffic data of the at least one other geographical region); based on the set of traffic data of the geographical region and the at least one set of traffic data of the at least one other geographical region, analyzing a mobility flow of the geographical area to determine at least one correlation between (trends in) the traffic data of the target geographical region and the at least one other geographical region; and generating a combined traffic forecast (or a final forecast or cumulative forecast or overall forecast) by adjusting the seasonal forecast for the target geographical region based on the at least one other seasonal forecast and the determined at least one correlation; and predicting emissions produced by traffic in the target geographical region based on the final traffic forecast.

According to a third aspect according to claim 12, there is disclosed herein an information processing apparatus comprising a memory and a processor connected to the memory, wherein the processor is configured to: based on a plurality of sets of (historical) traffic data of a plurality of geographical regions, respectively, perform a parameter determination process comprising: clustering the sets of traffic data based on similarity to each other to generate a plurality of clusters of the sets of traffic data; for each cluster comprising a plurality of sets of traffic data, selecting as a representative set of traffic data the set of traffic data of the cluster which is most similar to an average of the sets of traffic data of the cluster; and based on a representative set of traffic data corresponding to a target geographical region, performing mobility analysis to determine (optimal) parameters for a seasonal traffic forecast for the target geographical region and, based on at least one representative set of traffic data corresponding to at least one other geographical region, performing mobility analysis to determine (optimal) parameters for at least one other seasonal traffic forecast for the at least one other geographical region; perform a traffic forecasting process for the target geographical region using the set of traffic data of the target geographical region and the at least one set of traffic data for the at least one other geographical region, the traffic forecasting process comprising: based on the set of traffic data of the target geographical region, and using the determined parameters for the seasonal traffic forecast for the target geographical region, generating the seasonal traffic forecast (predicting traffic data in a future time period) for the target geographical region (by estimating a seasonal component of the traffic data of the target geographical region); based on the at least one set of traffic data of the at least one other geographical region, and using the determined parameters for the at least one other seasonal traffic forecast for the at least one other geographical region, generating the at least one other seasonal traffic forecast (predicting traffic data in a future time period) for the at least one other geographical region (by estimating a seasonal component of the traffic data of the at least one other geographical region); based on the set of traffic data of the geographical region and the at least one set of traffic data of the at least one other geographical region, analyzing a mobility flow of the geographical area to determine at least one correlation between (trends in) the traffic data of the target geographical region and the at least one other geographical region; and generating a combined traffic forecast (or a final forecast or cumulative forecast or overall forecast) by adjusting the seasonal forecast for the target geographical region based on the at least one other seasonal forecast and the determined at least one correlation; and predict emissions produced by traffic in the target geographical region based on the final traffic forecast.

Features relating to any aspect/embodiment may be applied to any other aspect/embodiment.

Reference will now be made, by way of example, to the accompanying drawings, in which:

Figure 1 is a diagram useful for understanding forecasting;
Figure 2 is a diagram illustrating a system and architecture;
Figure 3 is a diagram illustrating a system;
Figure 4 is a diagram illustrating a system;
Figure 5 is a diagram illustrating a method;
Figure 6 is a diagram illustrating a method;
Figure 7 is a diagram illustrating a module;
Figure 8 is a diagram useful for understanding embodiments;
Figure 9 is a diagram illustrating a module;
Figure 10 is a diagram useful for understanding embodiments;
Figure 11 is a diagram useful for understanding embodiments;
Figure 12 is a diagram useful for understanding embodiments;
Figure 13 is a diagram illustrating a module;
Figure 14 is a diagram useful for understanding embodiments;
Figure 15 is a diagram useful for understanding embodiments;
Figure 16 is a diagram useful for understanding embodiments;
Figure 17 is a diagram useful for understanding large-scale forecasting;
Figure 18 is a diagram illustrating a system and architecture;
Figure 19 is a diagram illustrating a system;
Figure 20 is a diagram illustrating a system;
Figure 21 is a diagram illustrating a method;
Figure 22 is a diagram illustrating a module;
Figure 23 is a diagram useful for understanding embodiments;
Figure 24 is a diagram illustrating graphs useful for understanding embodiments;
Figure 25 is a diagram illustrating a module; and
Figure 26 is a diagram illustrating an apparatus.

Aspects disclosed herein may handle the problem of estimating emissions, e.g., $CO_2$ emissions, that is, how to monitor past, current, and future emissions. Aspects may support reaching Net Zero Targets (NZT) by detecting abnormal peaks of emissions and e.g., applying countermeasures.

Conventional techniques for monitoring traffic and/or emissions have drawbacks including the following:

- Traditional approaches do not provide seasonal and low-granularity predictions in high demand systems, such as real-time environments requiring no-delay responses.
- Conventional forecasts are not context-aware and nor do they consider complex patterns (e.g., correlated areas, citizens mobility flow, future events, etc.).
- In conventional approaches, $CO_2$ anomalies are treated as $CO_2$ levels but not analysed in depth as a component of mobility. Nor are the seasonal and trend agnostic aspects taken into consideration.

Aspects disclosed herein may enable large scalability for monitoring past, current, and future emissions. They may support reaching Net Zero Targets (NZT) by detecting abnormal peaks of emissions and e.g., applying countermeasures in digital twin (DT) solutions where large number of regions need to be managed at the same time with very short period of responses.

Conventional techniques for monitoring traffic and/or emissions have further drawbacks including the following:

- Conventional approaches for DT solutions need to handle from a hundred to a thousand regions at the same time, which means managing thousands of complex models in near real time.

Aspects disclosed herein may achieve advantages including the following:

- Scalable seasonal forecasting for DT systems.
- Context-aware forecast and anomaly detection at different levels, key for simulations and digital rehearsals
- Detection of abnormal behaviors with a better accuracy by being seasonal- and trend-agnostic.
- Large-scale executions for DT systems.
- Complexity reduction, which may be considered important for managing the necessary number of models when many regions need to be handled at the same time with short response times e.g., for real-time DT environments.

The following terms may be used in the description. The definitions are not exhaustive.

**5G** - 5th Generation technology standard for telecommunications.
**ACF** - Auto Correlation Function.
**AI** - Artificial Intelligence.
**AR** - Auto Regressive.
**ARIMA** - Auto Regressive Integrated Moving Average.
**BN** - Batch Normalisation.
**CNN** - Convolutional Neural Network.
**DL** - Deep Learning.
**DT** - Digital Twin.
**DX** - Digital Transformation.
**FC** - Fully Connected Network.
**IoT** - Internet of Things.
**ITS** - Intelligent Transportation System.
**MA** - Moving Average.
**LSTM** - Long-Short Term Memory.
**NZT** - Net Zero Targets.
**PACF** - Partial Auto Correlation Function.
**SARIMA** - Seasonal Auto Regressive Integrated Moving Average.
**SARIMAX** - Seasonal Auto Regressive Integrated Moving Average with eXogenous features.
**SDLTFP** - Supervised Deep Learning Based Traffic Flow Prediction.
**SVM** - Support Vector Machine.
**SVR** - Support Vector Regression.

It has been reported that the time series analysis-based techniques like the autoregressive integrated moving average (ARIMA) is one of the most precise methods for the prediction of traffic flow (e.g., in Mai T, Ghosh B, Wilson S (2012) Multivariate short-term traffic flow forecasting using Bayesian vector autoregressive moving average model. Proceedings of the 91st Transportation Research Board Annual Meeting, Washington, D.C).

The time series models try to identify the pattern in the past data by decomposing the long-term trends and seasonal patterns and extrapolate that pattern into the future. Since the traffic flow pattern exhibits a strong seasonal pattern due to peak and off-peak traffic conditions which is repeating more or less at the same time every day, it is said that seasonal ARIMA (SARIMA) models are particularly relevant to model traffic flow behaviour (e.g., in Ghosh B, Basu B, Mahony MO (2007) Bayesian time-series model for short-term traffic flow forecasting. J Transp Eng 133(3):180-189). In many studies, the SARIMA model is found to perform better than the models based on random walk, linear regression, support vector regression (SVR), historical average, and simpleARIMA (e.g., in Williams BM, Hoel LA (2003) Modeling and forecasting vehicular traffic flow as a seasonal ARIMA process: theoretical basis and empirical results. J Transp Eng 129(6):664-672, in Ghosh B, Basu B, Mahony MO (2005) Time-series modelling for forecasting vehicular traffic flow in Dublin. Proceedings of the 85th Transportation Research Board Annual Meeting, Washington, D.C, and in Lippi M, Bertini M, Frasconi P (2013) Short-term traffic flow forecasting: an experimental comparison of time-series analysis and supervised learning. IEEE Trans intell Transp Syst 14(2):871-882).

An ARIMA model is characterized by 3 terms: **p, d, q,** where **p** is the order of the **AR** term, **q** is the order of the **MA** term, and **d** is the number of differencing to make the time series stationary. In a SARIMA model, the **s** term refers to the seasonal parameter and usually represents the number of observations in a season. Additionally, SARIMA can also be implemented with exogenous features, resulting in a SARIMAX model (e.g., as described in Khandelwal, R., 2020: Time series prediction using SARIMAX). These exogenous features have a different origin than the original time series. This means that the features describe other characteristics of the observations than the time series does. The addition of these features may lead to a more precise forecast of the time series. An example of these added features can be the weather or a list of events with their respective impact happening in specific areas of interest.

A standard way in literature and research to assign the correct values to the parameters **p, d, q,** is to use autocorrelation function (ACF) and partial autocorrelation (PACF) plots. ACF plot is a bar chart of the coefficients of correlation between a time series and its lags. It helps determine the value of **p** or the **AR** term. PACF plot is a plot of the partial correlation coefficients between the series and lags of itself and helps to determine the value of **q** or the **MA** term.

Some aspects disclosed herein may be considered an additional extension on the SARIMAX model. Some aspects disclosed herein may have the capability to scale up to a large number of regions for forecasting and anomaly detection.

Many companies and governments are currently involved in deep DX processes to evolve their traditional business for the future. In that transition, DTs are taking a relevant place for emulating the real world, mimicking behavioural models, and applying a future vision of the real world.

Aspects disclosed herein may facilitate the prediction of traffic emissions and the detection of abnormal behaviours for DT solutions. Conventional forecast approaches may be unable to deal with specific constraints and/or to provide specific features for a DT environment, such as special features that enable realistic digital rehearsals or advance simulations in DTs.

Aspects disclosed herein may achieve the following:

1. Scalable Seasonal Forecasting for high demand systems with small granularity of information and near real-time responses.
2. Context-Aware Traffic Forecast at different levels for enabling digital rehearsal and advance simulation with the aim of detecting complex patterns that have an impact on future emissions.
3. Seasonal- and Trend-Agnostic anomaly detection e.g., for highlighting scenarios that penalize NZT achievements.

As disclosed herein, "traffic" may refer to vehicular traffic. The terms "mobility" and "traffic" may both be used to refer to traffic data from sensors and/or a digital twin.

Description will now be made of a first implementation which includes a number of implementation examples and aspects.

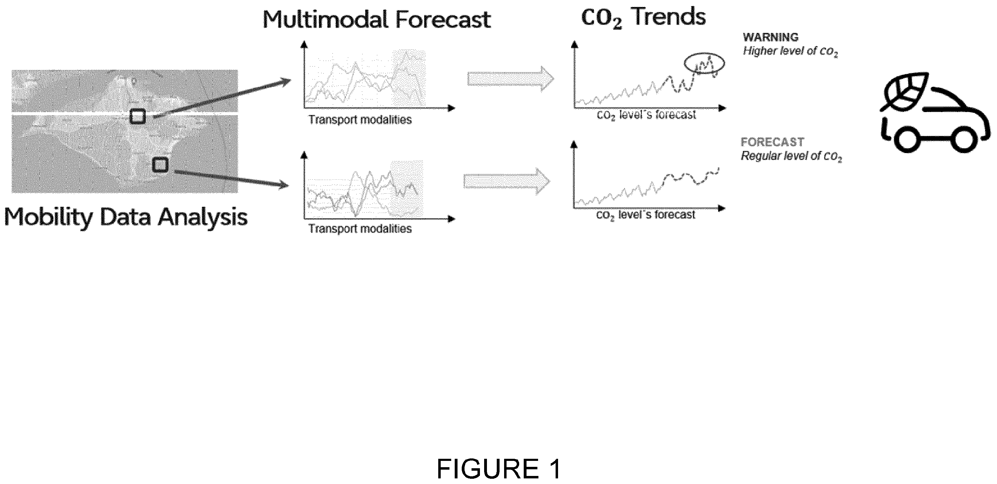

Figure 1 illustrates a representation of a practical use case. An analysis of the mobility of a region is carried out which provides insight about how the mobility is behaving. For such an analysis specific data from a DT environment with historical and real time data may be employed. This DT data together with the mobility insights are used for obtaining/-generating a forecast of the mobility (traffic) at different levels and considering a wider view of the mobility, with information such as: traffic, correlated areas, citizens mobility flow, events, weather, cross-sectorial modalities of transport, etc. Then, a detection of abnormal behaviour in the mobility (that has a direct impact on the pollutant emissions) is carried out. These anomalies unveil scenarios to further investigate: (1) for making decisions in the application of countermeasures for a potential reduction of the emissions, or (2) for analysing the scenario and obtaining best practices because of a reduction of the emissions levels. Furthermore, an estimation of pollutant emissions is obtained based on the forecasted traffic including the effect of potential anomalies.

DT systems can be aware of future levels of emissions and abnormal behaviours in early stages by incorporating aspects disclosed herein. The following advantages may be achieved by aspects disclosed herein: maintain precision while maintaining a small granularity of information; provide responses close to real-time for high demand systems such as DT environments; and reduce the complexity of the problem of forecasting (i.e., the models used, and computations required).

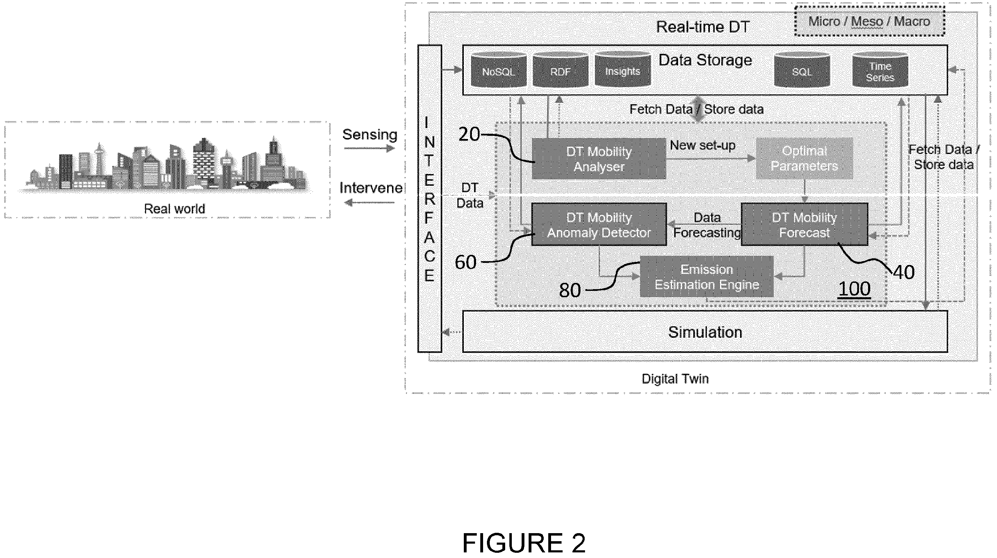

Figure 2 illustrates a general overview of an architecture incorporating system 100. System 100 may communicate with an interface to receive (live) data from sensors in the real world. The interface may also be connected with a Data Storage layer where data from such sensors is stored over time. The interface may also be connected to a simulation system e.g., for providing new insights about simulated scenarios.

System 100 comprises the following components which, in an implementation example, have the following functions:

- The DT Mobility Analyser module 20 is in charge of providing parameters for fine-tuning forecast models (described further below). The parameters may be referred to as "optimal" parameters. This is for example to illustrate that the parameters are generated based on an analysis and are considered useful. This module receives live information from the sensors placed in the real world, and historical information stored in the persistence layer (Data Storage), and it carries out a logic for obtaining the optimal set-up (parameters) for the forecasting models. As an output, the Optimal Parameters are provided to the DT Mobility Forecast module 40.

- The DT Mobility Forecast module 40 generates a forecast. That is, this module is in charge of predicting the behaviour of the different trends of mobility. It uses data such as historical data, mobility flow, events, weather, etc., and it performs a prediction after analyzing all these aspects. As output, this module provides a forecast of behavior of the traffic (a traffic forecast) e.g., with specific features to be used by the DT Mobility Anomaly Detector module 60 and for the Emission Estimation Engine 80.

- The DT Mobility Anomaly Detector module 60 detects abnormal behaviours in the forecasted traffic (which may impact the pollutant emissions). This module uses as inputs the forecasted behaviours from the DT Mobility Forecast module (and e.g., historical traffic data) and detects abnormal behavioural patterns agnostic to the seasonal component or the current trend of the mobility (traffic). As output, this module provides the abnormal behaviours detected with information about the pattern (expected behaviour, forecasted, type of anomaly, and deviation). This information is provided to the Emission Estimation Engine 80.

- The Emission Estimation Engine 80 estimates emissions, e.g., $CO_2$ or any other pollutant, based on the outputs of the DT mobility anomaly detector module 60 and the DT mobility forecast module 40. This may include specific information about the traffic, such as number of vehicles, type of vehicles, passengers, driving behaviour, etc. Additionally, this module estimates the impact of the abnormal behaviours detected and may be able to measure the impact of each anomaly from a sustainability perspective. This module may provide a quantification of the emissions for a given traffic situation.

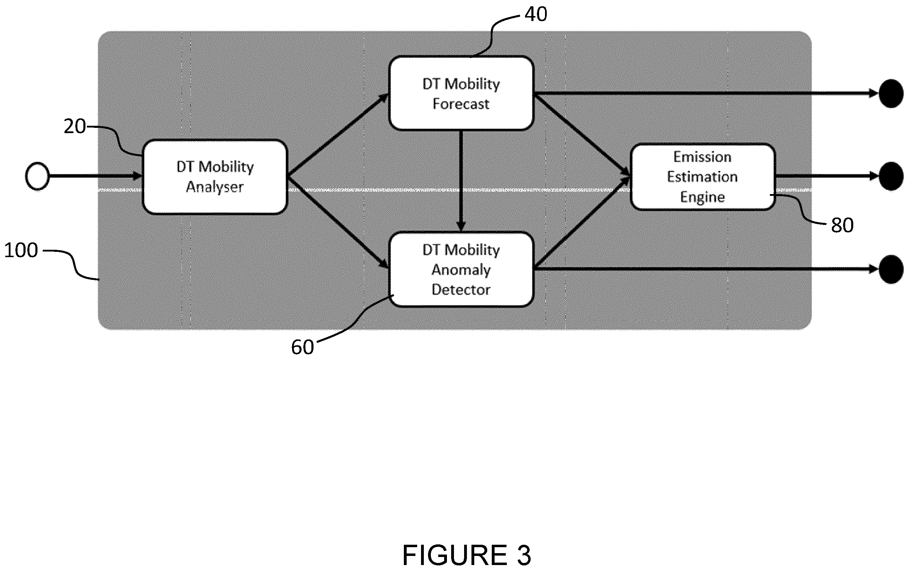

Figure 3 illustrates the system 100 and shows a processing flow using arrows.

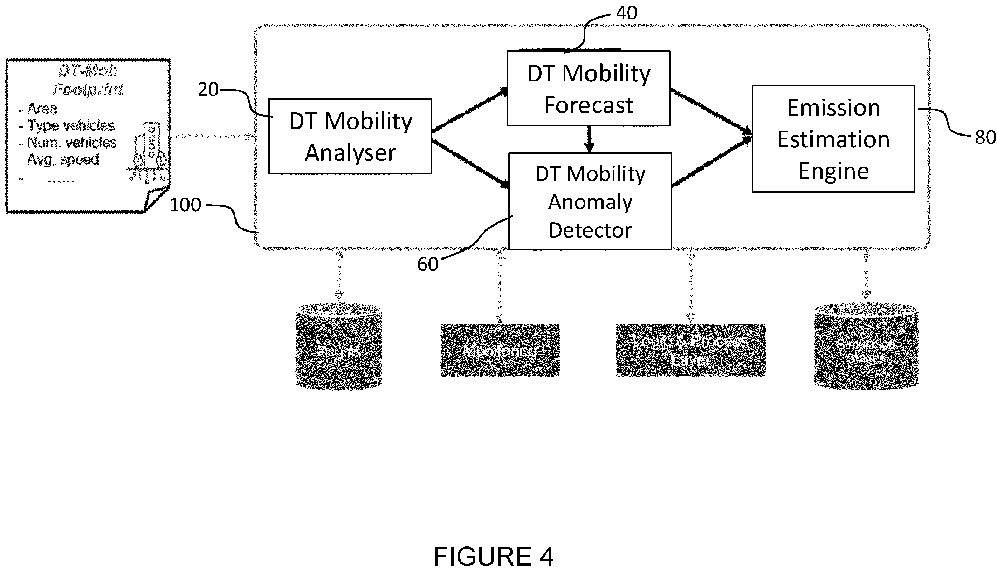

Figure 4 illustrates the system 100 as well as some inputs/communication features. The DT-Mob footprint represents data that may be received from a digital twin of a geographical area and may include any of vehicles counts, types of vehicles, speed, average speed, max speed, minimum speed, level of congestion, traffic jams (number of), level of use of the road network, max transit capacity, etc. (each of which being over time, i.e. time series data).

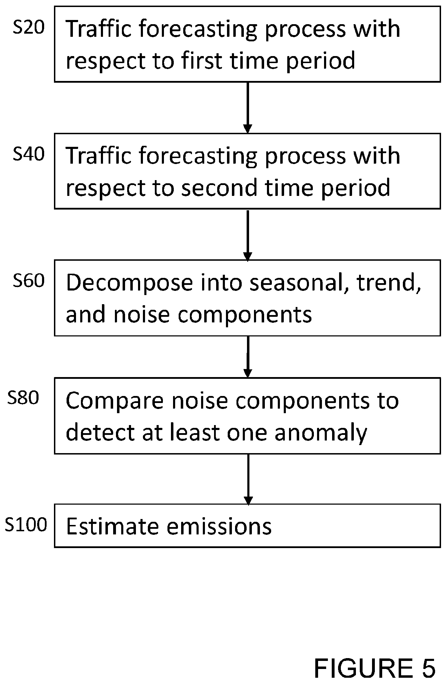

Figure 5 illustrates a method which may be performed by the system 100. Step S20 comprises performing a traffic forecasting process with respect to a first time period and step S40 comprises performing a traffic forecasting process with respect to a second time period. Performing a traffic forecasting process with respect to a time period here means performing a traffic forecasting process using traffic data covering that time period. For example, a time period may be the last ninety days or year or more or less. The first time period comprises the second time period and an additional time period more recent than the second time period. For example, the additional time period may be the previous hour or the previous day or week, etc. In some respects, (historical) traffic data covering the additional time period may be considered to "live" traffic data.

Traffic data as used herein (throughout this application, for the first and second implementations) may comprise data collected by sensors in the real world and e.g., stored in storage (e.g., storage layer). Alternatively, or additionally, traffic data as used herein may comprise data from a DT. That is, traffic data of a geographical area may be from a DT modelling/simulating that geographical area. The DT itself may utilize traffic data obtained from sensors in the real world. Traffic data from a DT may have undergone some pre-processing stages (compared to e.g. traffic data obtained from sensors in the real world) in which, for example, intermediate variables and values may have been generated i.e. levels of congestion for a concrete area and a concrete modality of transport given a number of vehicles and average speed of the vehicles.

Furthermore, traffic data as used herein may in some implementation examples comprise traffic data from a DT which is modelling/simulating particular scenarios (and e.g., not just the real world as it is). That is, a DT can model/simulate scenarios such as e.g., intervention scenarios (i.e., what would happen (to the traffic data) if a certain intervention was taken), and other "what-if" scenarios. Such scenarios may be considered to represent a mirror of the simulated near future or future given a set of parameters to be simulated. There could be multiple DT scenarios being simulated in parallel (and therefore multiple sets of corresponding traffic data).

As indicated above, traffic data as used herein may refer to/comprise traffic data obtained from sensors in the real-world (e.g., via storage) and data from a DT.

Steps S20 and S40 result in first and second traffic forecasts, respectively.

Step S60 comprises decomposing the first traffic forecast into first seasonal, trend, and noise components and decomposing the second traffic forecast into second seasonal, trend, and noise components. Step S60 may comprise using a Seasonal Trend Decomposition with LOESS (locally estimated scatterplot smoothing), STL, technique.

Step S80 comprises comparing the noise components to detect at least one anomaly. That is, step S80 comprises comparing the first noise component of the first traffic forecast with the second noise component of the second traffic forecast to detect at least one anomaly. Step S80 may comprise comparing at least one deviation between the first and second noise components to an anomaly threshold and, if the deviation is greater in magnitude than the anomaly threshold, classifying the deviation as an anomaly.

Step S100 comprises estimating emissions. This estimation is based on the first traffic forecast and may include the impact of the at least one detected anomaly.

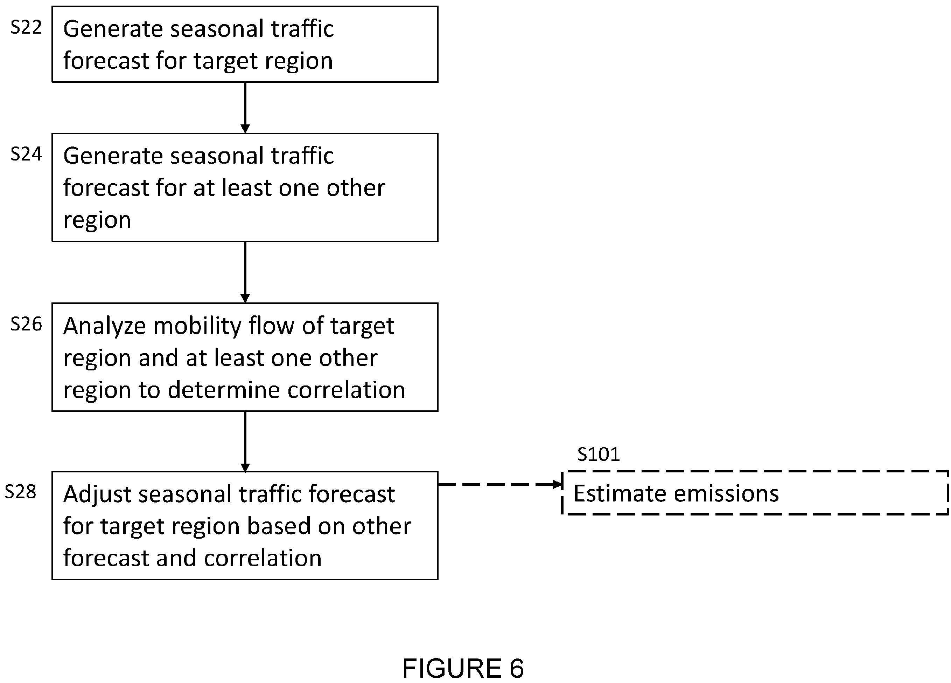

Figure 6 illustrates a method. Steps S22-S28 may be considered a traffic forecasting process. Steps S20 and S40 of the Figure 5 method may each comprise the traffic forecasting process of steps S22-S28.

Step S22 comprises generating a seasonal traffic forecast for a target region. Step S22 comprises generating at least one other seasonal traffic forecast for at least one other region. The regions are geographical regions among a plurality of geographical regions within a geographical area. The generation of a seasonal traffic forecast is described in more detail later below.

Step S26 comprises analyzing a mobility flow of the target region and at least one other region to determine a correlation between the target region and at least one other region.

Step S28 comprises adjusting the seasonal traffic forecast for the target region based on the at least one other forecast for the at least one other region and based on the determined correlation. The adjusted forecast may be referred to as a combined traffic forecast or a final forecast or cumulative forecast or overall forecast, and may be considered a final traffic forecast for the target region. These terms may be used interchangeably herein (in the first and second implementations).

Step S101 comprises estimating emissions based on the adjusted/final forecast. The method may or may not comprise step S101.

## DT Mobility Analyser module 20

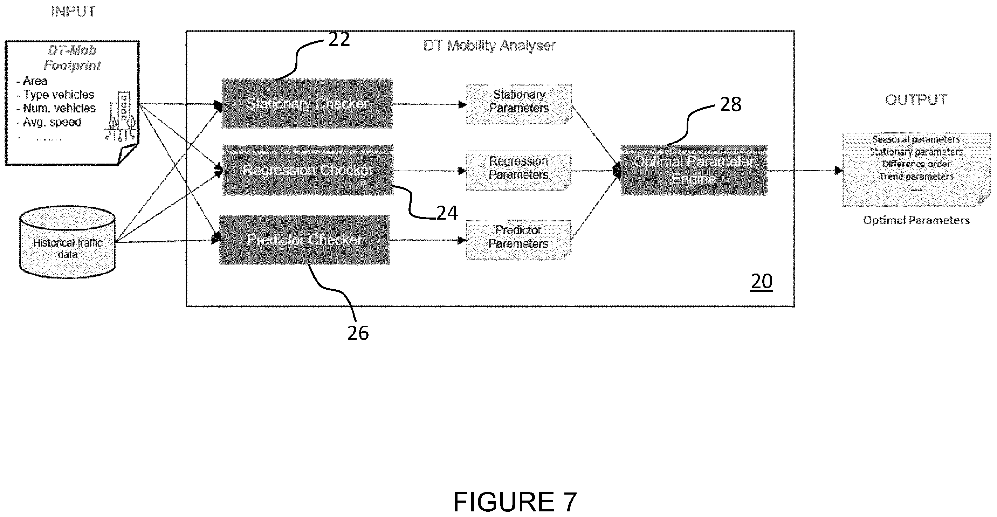

Figure 7 is a diagram illustrating a particular implementation example of the DT mobility analyzer module 20.

This module receives information/data from sensors in the real world and (historical) traffic data which may be stored into the Data Storage layer. This module analyses DT behaviours and finds the optimal parameters for the forecasting models. The DT Mobility Analyser module 20 may be considered to receive as input a DT-Mob footprint and "historical" data which may provide all the information required from the DT (as mentioned above, traffic data may be received from sensors and/or storage and/or a DT). The Mobility Analyser module 20 analyses the received information and identifies current trends in the mobility and sets up the optimal parameters for the forecasting models. This module has the capability of analysing the mobility from different angles (e.g., any of vehicles counts, speed, average speed, max speed, minimum speed, level of congestion, traffic jams (number of), level of use of the road network, max transit capacity, etc. Vehicle counts (i.e., number of vehicles or number of vehicles of each of a number of types) and (average) speed may be preferred in some examples (for example because these aspects may be used to compute emissions.). A type of vehicle may correspond with any of an engine size, an average emission amount, and a manufacturer.

The optimal parameters may be determined by testing the execution with a set of parameters and comparing the error with metrics for each configuration and selecting the best (i.e., selecting parameters that provide the smallest error).

The DT mobility analyzer module 20 may be considered to carry out part of step S22 and part of step S24, in the sense that generating a seasonal forecast may include first analyzing the traffic data concerned to determine optimal parameters for the seasonal forecast.

As can be seen in Figure 7, in this implementation example the DT Mobility Analyser module 20 has four components:

### Stationary Checker 22

This component analyses the traffic data and obtains the different levels of stationarity of a yearly trend. In other words, this component provides the variations of the historical trends depending on the period of the year. For obtaining the optimal parameters this module may use techniques such as the Canova-Hansen to determine the optimal order of seasonal differencing.

Regression Checker 24

This component analyses the historical data added to current live information of the mobility. This may be considered simply as analysing the traffic data. This module establishes a relation among historical data, current mobility trend and future prediction. This may be considered as determining relations between mobility trends in the past, more recent mobility trends, and provisionally predicted mobility trends. Ultimately in this implementation example this component provides the number "waves" that the analysed mobility trends follow, in order to achieve an accurate forecast.

Some examples of techniques that can be used by this module include: Kwiatkowski-Phillips-Schmidt-Shin, Augmented Dickey-Fuller, or Phillips-Perron techniques.

Predictor Checker 26

This component establishes the range of values in which the current mobility trend is oscillating. In other words, this module determines one or more parameters which establish the order of magnitude or ratio of grow/decrease for future values in the mobility trend. Some techniques for determining these parameters may include the autocorrelation function (ACF), partial autocorrelation function (PACF), and/or extended autocorrelation function (EACF) method.

In order to find optimal parameters, these modules 22, 24, 26 may use techniques such as Akaike Information Criterion, Corrected Akaike Information Criterion, Bayesian Information Criterion, Hannan-Quinn Information Criterion, or "out of bag" for the validation.

Optimal Parameter Engine 28

This component aggregates the stationary, regression and predictor parameters (and may e.g., set the parameters in the correct fields and order for use in the next stage).

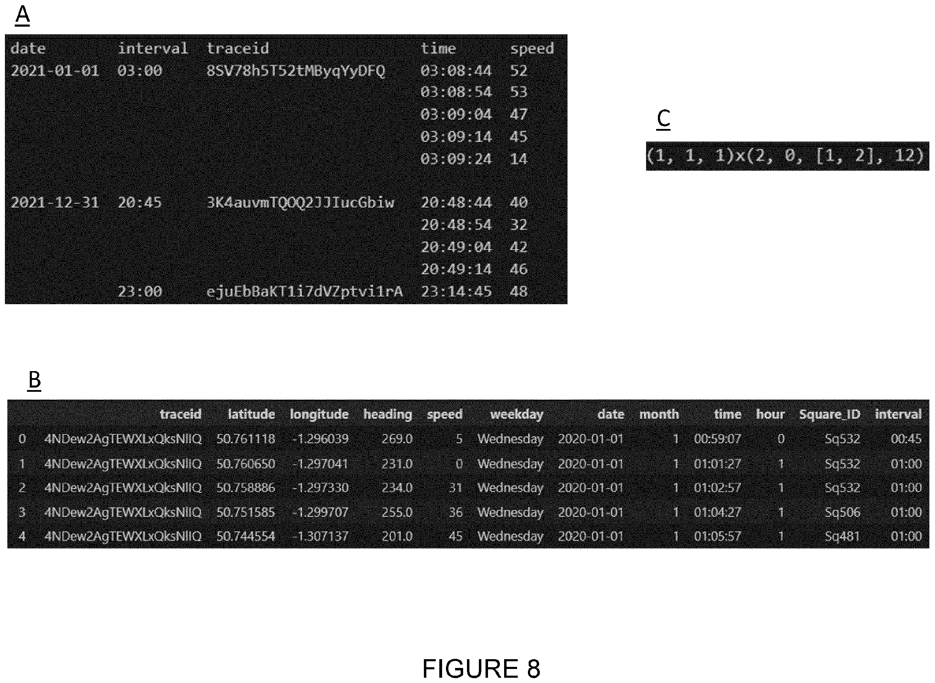

Figure 8 illustrates some example data with respect to the DT Mobility Analyser module 20. A illustrates an example of data included in a DT-mob footprint. B illustrates an example of traffic data stored in the data storage. Both of A and B together may be considered traffic data. C illustrates an example of parameters aggregated together by the optimal parameter engine 28.

The Optimal Parameters may be provided to the DT Mobility Forecast module 40.

**DT Mobility Forecast module 40**

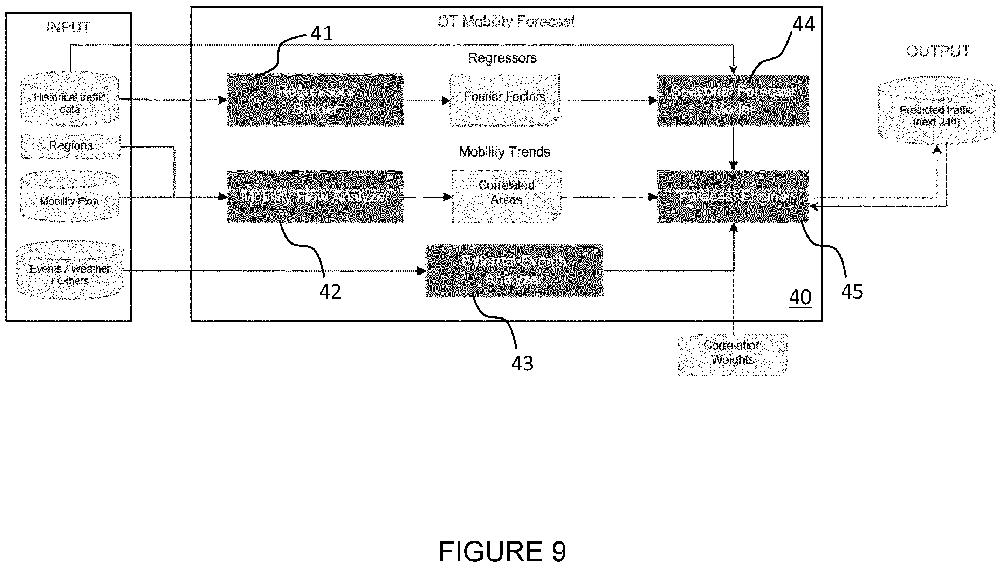

Figure 9 is a diagram illustrating a particular implementation example of the DT mobility forecast module 40.

The DT Mobility Forecast module 40 predicts the behaviour of the different trends of mobility. This module uses as input data of historical mobility, mobility flow, events, and weather, among other datasets, (which may be referred to together as traffic data) and it performs a prediction after analyzing such aspects. As output, this module provides a forecasted behavior of the traffic, i.e., a traffic forecast, which may include specific features to be used by the DT Mobility Anomaly Detector module 60 and the Emission Estimation Engine 80. Data of mobility may be considered traffic data.

The DT Mobility Forecast module 40 of this implementation example shown in Figure 9 has five components.

Regressors Builder 41

The Regressors Builder 41 contributes to a scalable seasonal forecast. This component analyses the historical data for the mobility (i.e., the traffic data) and generates Regressors that define the seasonal aspect of the forecast. These Regressors are provided to the Seasonal Forecast Model module 44. Thus, the computational cost for estimating the seasonal component in the forecast is separated from the generation of the seasonal forecast and is performed by the regressors builder 41 instead of the seasonal forecast model module 44, which may aid in reducing complexity and computational cost. The regressors builder 41 may provide the Regressors as Fourier Factors to the Seasonal Forecast Model module 44. The regressors builder 41 may use techniques such as Fourier Transforms, Sinusoidal Decomposition, and functions of Time and Frequency.

Seasonal Forecast Model Module 44

The Seasonal Forecast Model module 44 is in charge of the seasonal forecasting for the mobility. This module uses the historical traffic information (i.e., traffic data) and the Regressors. The use of Fourier Factors as regressors may reduce the complexity of the training. In the training phase the parameters of the model (seasonal forecast model) may be configured based on the training data set. This model has some components for the stationary/seasonal part and the non-stationary/non-seasonal part. The regressors may be considered to provide the information of the seasonal component, making it simpler to set-up the model as it only needs to be trained the non-stationary/non-seasonal component, thereby reducing the time and the complexity of the Seasonal Forecast Model set-up/training.

Use of the regressors may also reduce complexity during the execution of the model. The model is defined by the equation below. The Seasonal Forecast Model module 44 uses the Optimal Parameters provided by the DT Mobility Analyser module 20 with the aim to provide an optimal set-up of the model(s) used in the forecast/prediction.

The model(s) used in the Seasonal Forecast Model Module 44 to generate the seasonal forecast may be defined by the equation below:

$$\Phi(L)^q \phi(L^S)^Q \Delta^d \Delta_s^D \epsilon_t + \sum_{i=1}^{n} \beta_i x_t^i$$

where:

$\Phi(L)^q$ - An order **q** polynomial function of **L.**
**L** - Lag operator.
**q** - Number of time lags of the error term to regress on.
$\phi(L^S)^Q$ - An order **Q** polynomial function of $L^S$.
$L^S$ - Seasonal lag operator.
**Q** - Number of seasonal time lags.
$\Delta^d$ - Integration operator for non-stationary data.

$\Delta_s^D$ - Differencing operator for eliminate seasonal aspect **s** in a **D** order.

$\epsilon_t$ - Noise at time **t.**

$\sum_{i=1}^{n} \beta_i x_t^i$ - **n** - n exogenous variables defined at each time step **t,** denoted by $x_t^i$ for i≤**n,** with coefficients $\beta_i$.

The seasonal forecast model module 44 may be considered to carry out steps S22 and S24.

The generation of the regressors may be carried out by the seasonal forecast model module 44 instead of the regressors builder 41. Equations other than that shown above may be used to generate the seasonal forecast.

Mobility Flow Analyzer 42

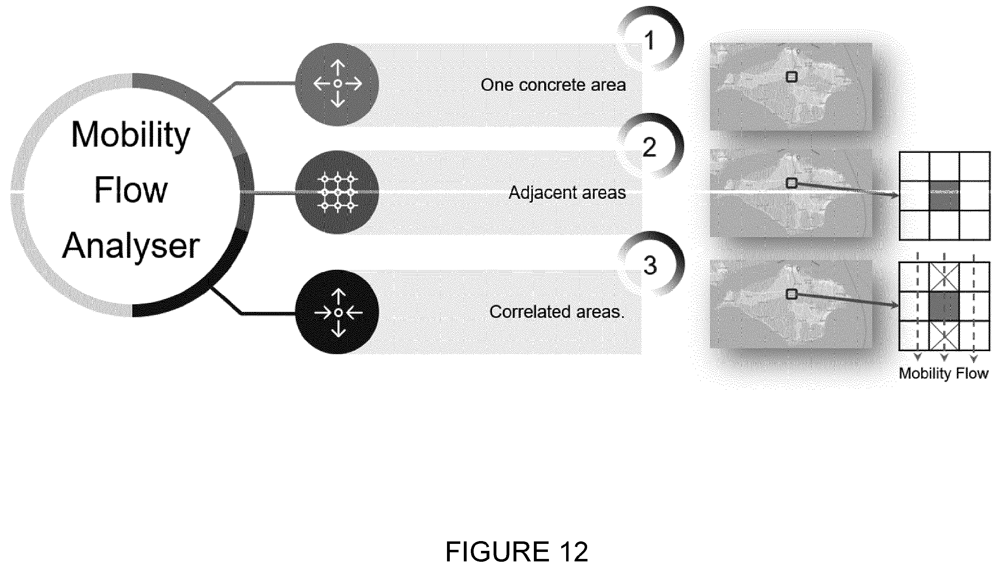

The Mobility Flow Analyser 42 provides insights about how regions are related to one another and how the mobility in one region may be correlated with the mobility in other region(s), and ultimately how the traffic forecasts for different regions may be correlated with each other. This component enables mobility flow analysis at, for example, three levels as illustrated in Figure 12. For example, correlation(s) can be searched for: (1) at the region level (i.e., within a geographical region), (2) considering adjacent regions, or (3) considering the region(s) that affect a target region based on a mobility flow analysis (which may include adjacent and non-adjacent regions). Finally, this module provides as final result the regions that need to be considered for a realistic forecast. That is, the Mobility Flow Analyser 42 may output information indicating at least one region whose traffic data has an effect on the traffic data of the target region based on the traffic data analysed. The Mobility Flow Analyser 42 may also determine at least one correlation and output this information, or the at least one correlation may be determined by the forecast engine 45.

The mobility flow may be defined as the impact of traffic data in one region on traffic data in any other region. The mobility flow may be defined as how people move from one region to another (e.g. their destination) regardless of the modality of transport.

Two approaches may be considered to analyse mobility or origin-destination (OD) matrices from call detail records (CDRs)la: (a) in time-based matrices, the analysis may focus on estimating mobility directly from a sequence of CDRs; (b) in routine-based matrices (OD by purpose) the analysis may focus on routine kind of movements, like home-work commute, derived from a trip generation model. Additionally, this module may map the OD coordinates for concrete periods to the distribution of the regions.

The mobility flow analyzer 42 may be considered to carry out step S26.

External Events Analyser 43

The External Events Analyser 43 provides insights about how external factors are considered for the final forecast. This component analyses the correlation of such external factors (for example events, weather situations, complex correlated patterns, or other factors that impact the mobility, i.e., the traffic information) with the traffic information. Such correlations are transmitted to the forecast engine 45 where they may be considered together with future possible events to adjust the traffic forecast.

The External Events Analyser 43 may use techniques such as any of time series correlation (Pearson correlation, or linear regression techniques), networks correlation (graphlet network distances, alignment-based methods, spectral methods, or other), and Data Mining methods, to analyse correlation between events and some variables.

Forecast Engine 45

The Forecast Engine 45 provides the final forecast which is output by the DT Mobility Forecast module 40. The Forecast Engine 45 receives information from the Seasonal Forecast Model module 44, the Mobility Flow Analyser 42, and the External Events Analyser 43. The Forecast Engine 45 selects the seasonal forecast for a target region and analyses the impact of: (1) the mobility flow, (2) the behaviour of surrounding/correlated region(s), (3) the events happening in the future, (4) the influence of the weather, and (5) the correlation between other complex patterns that has an impact on the mobility forecast, among other possible factors. The forecast engine 45 adjusts the seasonal forecast based on any of these factors. The forecast engine 45 may use the equation below to compute the adjusted forecast, which may be referred to as a final forecast. The forecast engine 45 may receive correlation weights which may be determined in advance (e.g., though training and/or statistical interference) and which may be used as the coefficients in the equation below.

$$SF_i = \alpha_i \cdot f_{si}(x_t) + \beta_j \cdot \sum_j^n f_{sj}(x_t) + \gamma_k \cdot \sum_k^m e_{ik}(x_t^{ik}) + \sum_j^n \delta_j \cdot w_i(x_t) + \varepsilon_l \cdot cp_{il}(x_t) + \epsilon_t$$

where

$\alpha_i$ - Seasonal Forecast coefficient for region **i.**
$f_{si}(x_t)$ - Seasonal Forecast for principal region **i.**
$\beta_j$ - Seasonal Forecast coefficient for each correlated region **j.**

$\sum_j^n f_{sj}(x_t)$ - Seasonal Forecast for each correlated region **j.**

$\gamma_k$ - Events coefficient for event **k.**

$\sum_k^m e_{ik}(x_t^{ik})$ - Estimation impact function for each event **k** in the principal region **i.**

$\delta_j$ - Weather coefficient per each region **j.**
$w_i(x_t)$ - Weather impact function for principal region **i.**
$\varepsilon_l$ - Complex Pattern coefficient for each pattern **l.**
$cp_{il}(x_t)$ - Complex Pattern **l** correlated with the principal region **i.**
$\epsilon_t$ - Noise at time **t.**

The forecast engine 45 may be considered to carry out step S28.
Equations other than that shown above may be used, for example equations with not all of the terms in the above equation, among other possible equations.

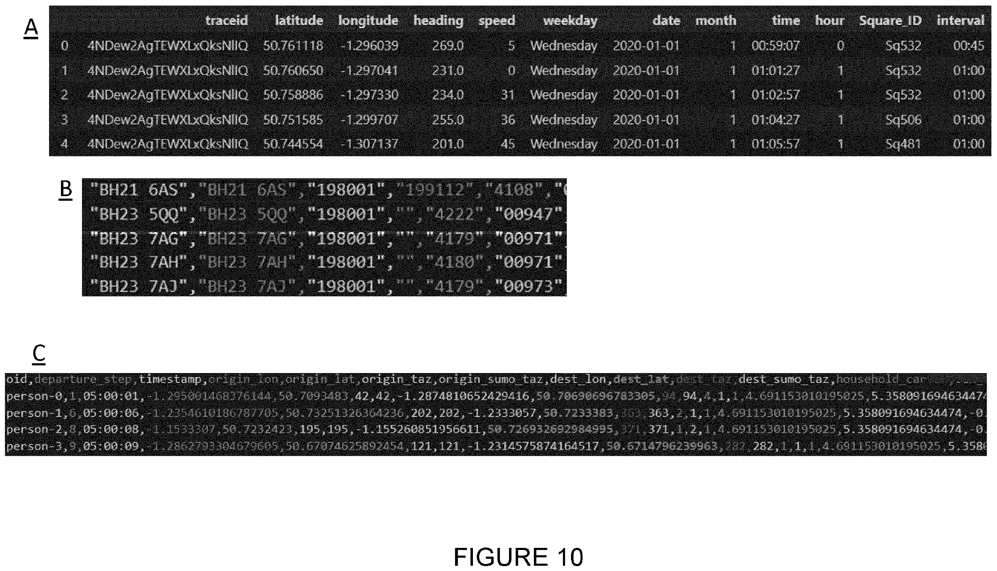

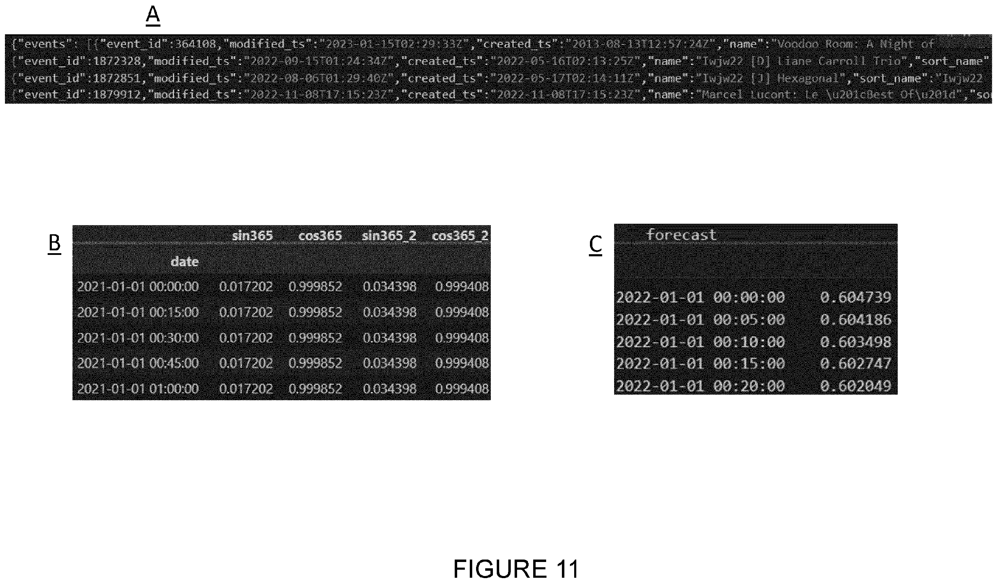

Figure 10 illustrates some example data that may be input to the DT mobility forecast module 40. A illustrates some example "historical traffic" data". B illustrates some example region information. c illustrates some example "mobility flow" data. Figure 11 illustrates some further example data. A illustrates example external events data. B illustrates some example data regarding the regressors. C illustrates some example data related to a traffic forecast (in this example case, specifically, the number of vehicles is shown). The data input to the DT mobility forecast module 40 may simply be referred to as traffic data. That is, traffic data as used herein may include data about events, mobility flow, region information, etc.

## DT Mobility Anomaly Detector 60

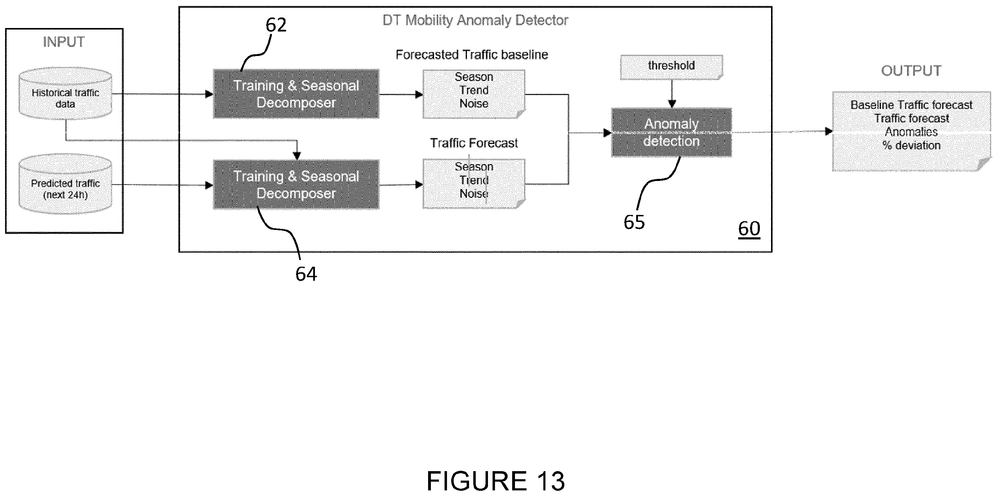

Figure 13 is a diagram illustrating a particular example implementation of the DT mobility anomaly detector 60.
The DT Mobility Anomaly Detector module detects abnormal behaviours in the traffic forecast which may impact the pollutant emissions prediction. The DT Mobility Anomaly Detector 60 uses as inputs the historical traffic data and specific forecasted behaviours from the DT Mobility Forecast module for detecting abnormal behavioural patterns agnostic to the seasonal component or the current trend of the mobility. As shown in Figure 13, the DT mobility anomaly detector 60 comprises in this implementation example three modules: two Seasonal Decomposer modules 62, 64, one for decomposing the "expected" traffic behaviour and another for the decomposition of "forecasted" traffic behaviour, and an anomaly detection module 65 for detecting anomalies based on the outputs of the two seasonal decomposer modules 62, 64.

As output, the DT Mobility Anomaly Detector 60 may provide the abnormal behaviours detected with information about the pattern (expected behaviour, forecasted, type of anomaly, and deviation). This information may be provided to the Emission Estimation Engine 80.

Seasonal Decomposer modules 62, 64

Each Seasonal Decomposer module 62, 64 decomposes the traffic behaviour into three aspects/components: (1) Seasonal component, (2) trend, and (3) the noise.

The seasonal aspect/component comprises information regarding the recurring variation of the traffic data based on a chosen time scale. That is, the seasonal component shows the recurring temporal pattern present in the traffic data based on the chosen seasonality. The chosen seasonality may be for example monthly or yearly or weekly, among other seasonalities.

The trend aspect/component comprises information regarding the variation of the traffic data over a longer time period than the time period defined by the seasonality. For example, if a monthly seasonality is chosen then the trend component will show the longer-term variation of the traffic data over a number of months. The trend component may be considered (and may be defined as) the traffic data with the seasonal component removed/subtracted, or the traffic data with seasonal variation eliminated.

The noise aspect/component may be referred to as the remainder component. The remainder component may be calculated by subtracting the values of the seasonal and trend component from the traffic data. Remainder values indicate the amount of noise present in the traffic data. Values close to zero indicate that the seasonal and trend components are accurate in describing the traffic data, whereas larger remainder values indicate the presence of noise.

The Seasonal Decomposer 62 uses as input the historical traffic behaviour and decomposes the expected behaviour in seasonal, trend and noise components. The other Seasonal Decomposer 64 uses as input the historical traffic data and the forecasted values from the DT Mobility Forecast module and decomposes the forecasted behaviour into seasonal, trend and noise components.

This decomposition can be carried out using e.g., Seasonal Decomposition with LOESS (STL) (https://doc. arcgis.com/en/insights/latest/analyze/stl.htm). The outputs from both Seasonal Decomposer modules 62, 64 are used as inputs for the Anomaly Detection module 65.

Anomaly Detection module 65

The Anomaly Detection module 65 is in charge of highlighting potential anomalies found based on the difference between the "expected" behaviour and the "forecasted" behaviour. This estimation is done from a seasonal- and trend-agnostic perspective, where only the "noise" or "deviation" aspect/component of the behaviour is analysed.

Thus, variation in traffic due to seasonal or trend factors, which are normal and should not be considered anomalous, are excluded from consideration when detecting anomalies.

As described above, the DT mobility anomaly detector 60 may receive historical data (traffic data) and forecasted behaviour as inputs. Instead, the DT anomaly detector 60 may receive as inputs first and second traffic forecasts generated by the DT mobility forecast module 40, where the first traffic forecast is based on traffic data covering the first time period and the second traffic forecast is based on traffic data covering the second time period, and where the first time period comprises the second time period and the additional time period more recent that the second time period, as described with respect to Figure 5. The first traffic forecast may be considered the "forecasted" behaviour and the second traffic forecast may be considered the "expected" behaviour. The second traffic forecast may be referred to as a traffic baseline forecast.

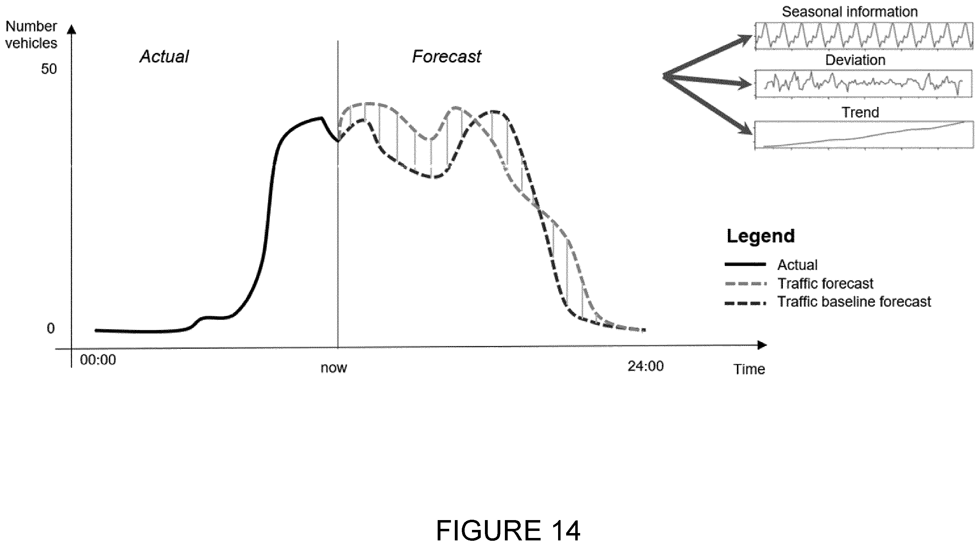

Figure 14 illustrates first and second traffic forecasts in terms of how a number of vehicles in a region changes with time. The "traffic forecast" in the light grey dashed line is the "forecasted behaviour" or the first traffic forecast, whilst the "traffic baseline forecast" in the dark grey/black dashed line is the "expected behaviour" or the second traffic forecast. The solid black line shows the actual traffic data up until a particular point in time (marked "now" in Figure 14). The graph in Figure 14 shows the deviation/noise component of the forecasts/data after the decomposition.

The anomaly detection module 65 compares a deviation/difference between the noise components of the first and second traffic forecasts with a threshold (an anomaly threshold) and if the deviation is greater in magnitude than the threshold, classifies the deviation as an anomaly. The percentage difference may be used, i.e., the deviation as a percentage of the value of the noise component of the first or second traffic forecast at the point in time concerned.

The Anomaly Detection module 65 may provide as output the following: the baseline traffic forecast, the traffic forecast, the anomalies found, and the percentage of deviation per each anomaly. This output is provided to the Emission Estimation Engine 80 for highlighting the anomalies from a pollutant point of view. The Anomaly Detection module 65 is able to detect anomalies based on different aspects of the traffic (e.g., any of vehicle counts, speed (average), type(s) of vehicle(s), number of each type of vehicle, road network density, max speed, minimum speed, level of traffic congestion, number of traffic jams, etc.). In an implementation example, anomalies are detected based on the number of vehicles and the average speed of vehicles.

The DT anomaly detector 60 may be considered to carry out steps S60 and S80.

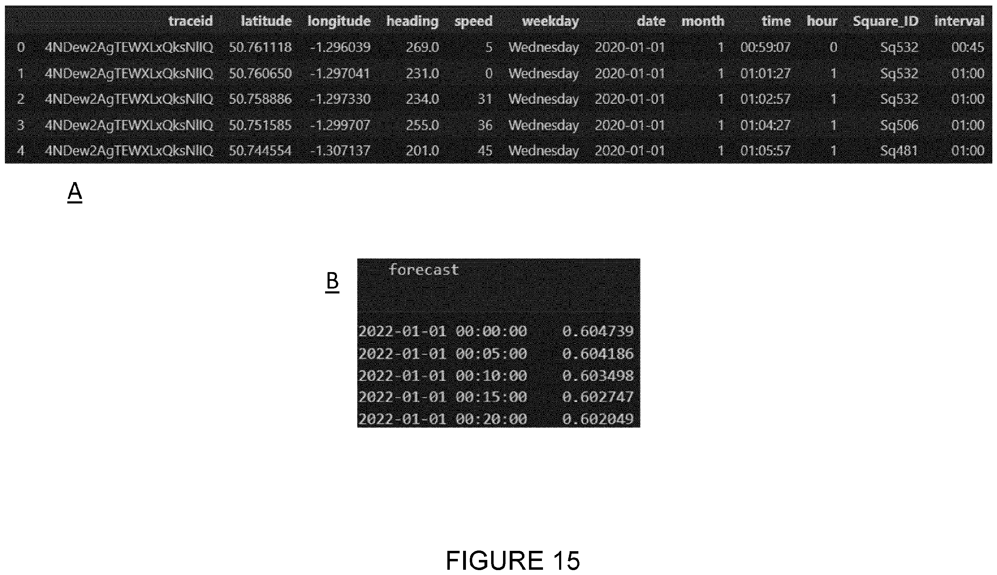

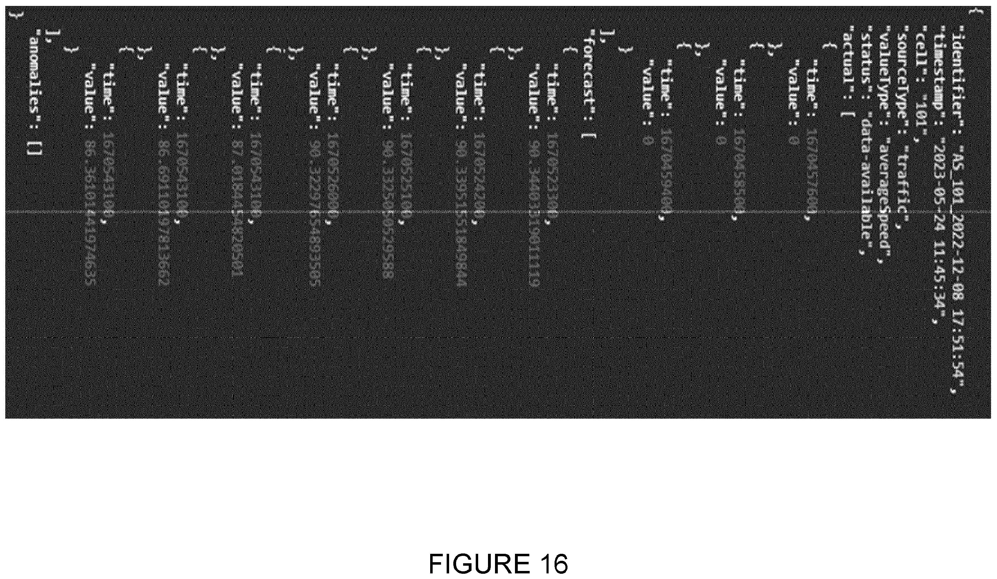

Figure 15 illustrates some example data with respect to the DT anomaly detector 60. A illustrates example "historical" traffic data. B illustrates example forecasted behaviour. Figure 16 illustrates some example output data of the anomaly detection module 65.

## Emission Estimation Engine 65

The Emission Estimation Engine 65 estimates the $CO_2$ emissions or any other pollutant emissions based on information of the predicted traffic, such as, number of vehicles, type of vehicles, passengers, driving behaviour, etc. This module thus provides the forecasted values for the emissions in the future based on the output of the DT Mobility Forecast module (i.e., the first traffic forecast). Any emissions may be predicted, for example any of the following emissions may be predicted: CO2, NO, NO2, CO, hydrocarbons, CH4, benzene, formaldehyde, chlorofluorocarbons, $CHClF_2$, Radon. For example, any of the following emissions may be predicted: carbon dioxide (CO2), carbon monoxide (CO), Nitrogen oxide (NO and/or NO2), methane (CH4), Chlorodifluoromethane ($CHClF_2$), Radon (Rn). Any hydrocarbon(s) emissions may be predicted instead of/in addition to CH4. Any chlorofluorocarbon(s) emissions may be predicted instead of/in addition to $CHClF_2$.

Additionally, this module estimates the impact of the abnormal behaviours/anomalies detected by the DT Mobility Anomaly Detector 60. That is, the emission estimation engine 65 measures the impact of each anomaly from a sustainability perspective. This module provides a quantification of the emissions for a given traffic situation.

In an implementation example the emissions are computed based on information indicating average emissions of a vehicle based on the speed, the number of vehicles from the traffic forecast and the average speed of vehicles from the traffic forecast. The emissions estimation may also take account of the different types of vehicles and may utilise information indicating for each type of vehicle the average emissions of a vehicle of that type based on the speed. The information indicating average emissions may be based on information provided by the vehicle manufacturer or determined by testing. Alternatively, or in addition to the average speed, average behaviour may be used. Average behaviour may comprise speed changes, acceleration, frequency of journeys, etc.

Description will now be made of a second implementation which includes a number of implementation examples and aspects.

Aspects disclosed herein may facilitate the management of large-scale solutions for predicting traffic emissions and optionally detecting abnormal behaviours for DT solutions. Conventional techniques for traffic forecasting may be unable to deal with specific constraints and to provide specific features for a DT environment. Conventional techniques may struggle with large-scale solutions, that is, handling many regions at the same time, optionally with quick response times.

Aspects disclosed herein may achieve the following advantages, among others:

1. **Large Scalable Executions** for Forecasting and Anomaly Detection for high demand systems.
2. **Complexity Reduction** in large-scale scenarios.

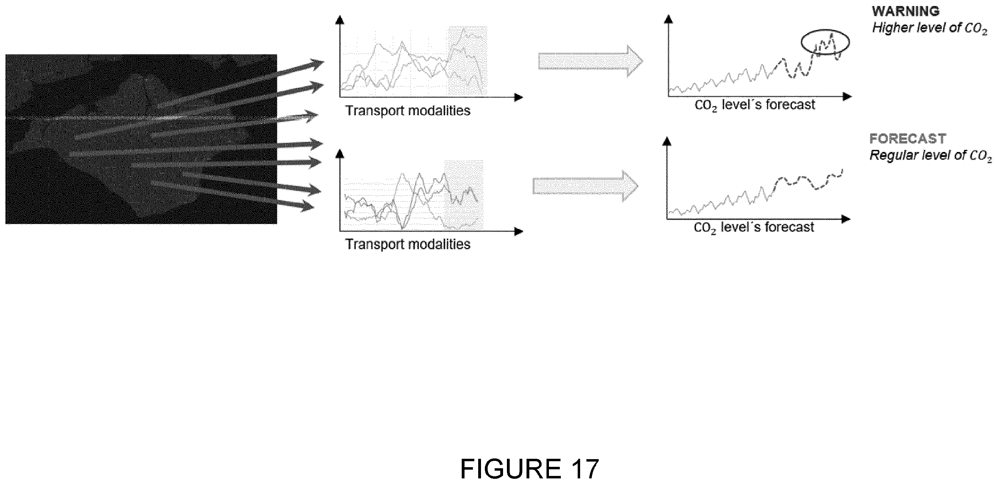

Figure 17 illustrates a representation of traffic forecasting for a large number of regions. In some cases, managing all the models required for a DT and for traffic forecasting using conventional approaches with hundreds or thousands of regions is not optimal. Aspects disclosed herein analyse the mobility in multiple regions to obtain insights about how the mobility is behaving. Data from a DT environment, with "historical" and "real-time" data may be used. Such data together with the mobility insights may be used for obtaining a classification of multiple regions managed covered by a DT. This classification is inferred based on the behavioural pattern of the mobility per each region. Each region is assigned a category, where the number of categories is lower than the number of regions managed.

For each category a representative behaviour is selected which is a behavioural pattern that is used to represent all the regions in the category. This representative behaviour may be determined by selecting a region's behavioural pattern that has a minimal difference with the other regions' behavioural patterns of the same category, or with an average of the region's behavioural patterns (traffic data). That is, a region may be selected to minimise the difference.

A relation between the number of categories and the error introduced by the categorising process may be determined (e.g., based on testing and/or example implementations of the second implementation). If the number of categories is small then the error introduced is larger, and vice versa. A configuration parameter may be set which defines the number of categories and/or an "acceptable" error (from which a number of categories may be determined based on the relation). A closeness threshold may be implemented which is related to the number of categories and/or an "acceptable" error. The closeness threshold may be used when clustering the sets of traffic data, in the sense that the closeness threshold may define a level of similarity that two sets of traffic data must share in order to be grouped together in the same category/cluster. In other words, in an implementation example a similarity between two sets of traffic data (e.g., between a centroid and another set of traffic data) may be compared with the closeness threshold and if the similarity is above the threshold, then the sets of traffic data may be clustered/categorised together - and otherwise they may not be. A closeness threshold may be implemented instead of or in addition to a number of categories and/or an "acceptable" error.

Considering the error introduced by the categorisation process, it may be said that the categorisation process reduces the complexity of the problem at the cost of error being introduced, but this can be mitigated somewhat/kept smaller (and therefore an accuracy of the ultimate output (emission estimation) may be maintained to a degree) by choosing an appropriate number of categories. As previously mentioned, the categorisation process facilitates the management of large-scale executions in a DT environment.

The representative behaviour is used to determine optimal parameters for a seasonal forecast. Forecasting and anomaly detection may be carried out (e.g., as described with respect to the first implementation) based on the determined optimal parameters. This saves computing power and time compared to determining optimal parameters for a forecast for every region individually.

The clustering/categorising and selection of a representative behaviour may be repeated at intervals, or each time new traffic data is obtained from the DT/real-world sensors.

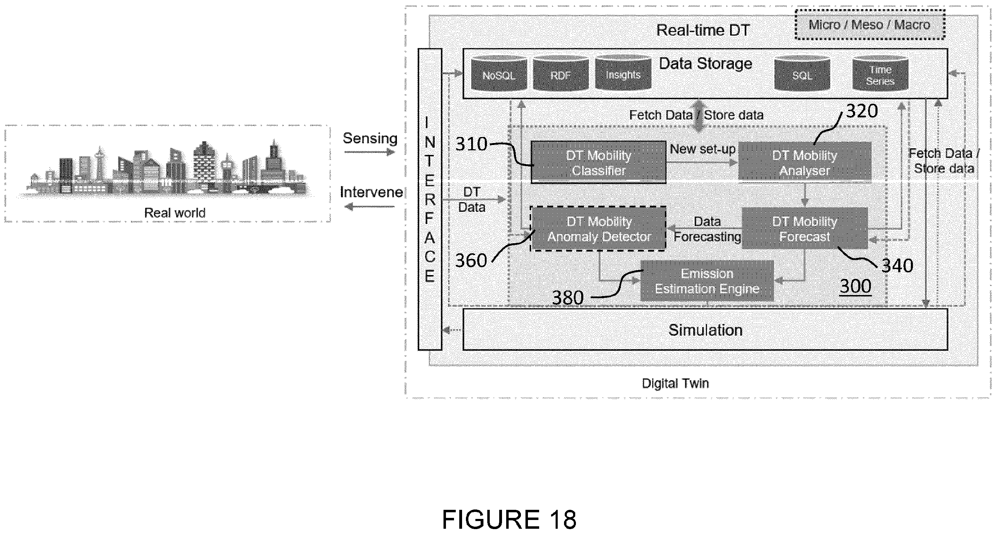

Figure 18 is a diagram illustrating a general overview of architecture incorporating system 300. The architecture and the system 300 are similar to the architecture and system 100 in Figure 2 and duplicate description is omitted.

A difference between system 100 and system 300 is that the system 300 comprises an additional component - the DT mobility classifier module 310.

The DT Mobility Classifier module 310 aids in handling a large number of regions. This module analyses historical and live information (may be referred to together as traffic data), categorises multiple regions based on their mobility behavioural patterns, and selects a number of representative regions that represent the behaviour of all the regions considered. As outputs, the representative regions are provided to the DT Mobility Analyser module 320 and to the DT Mobility Forecast module 340.

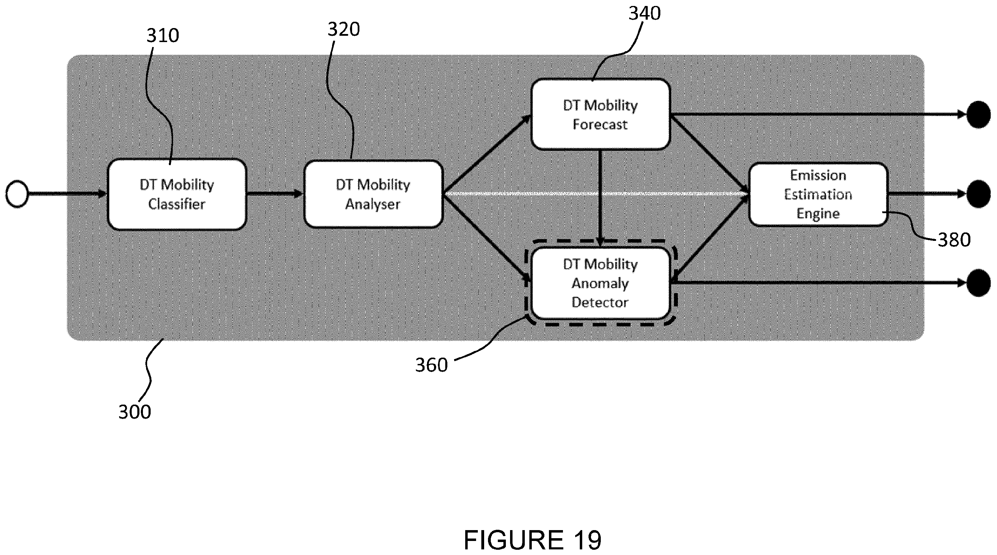

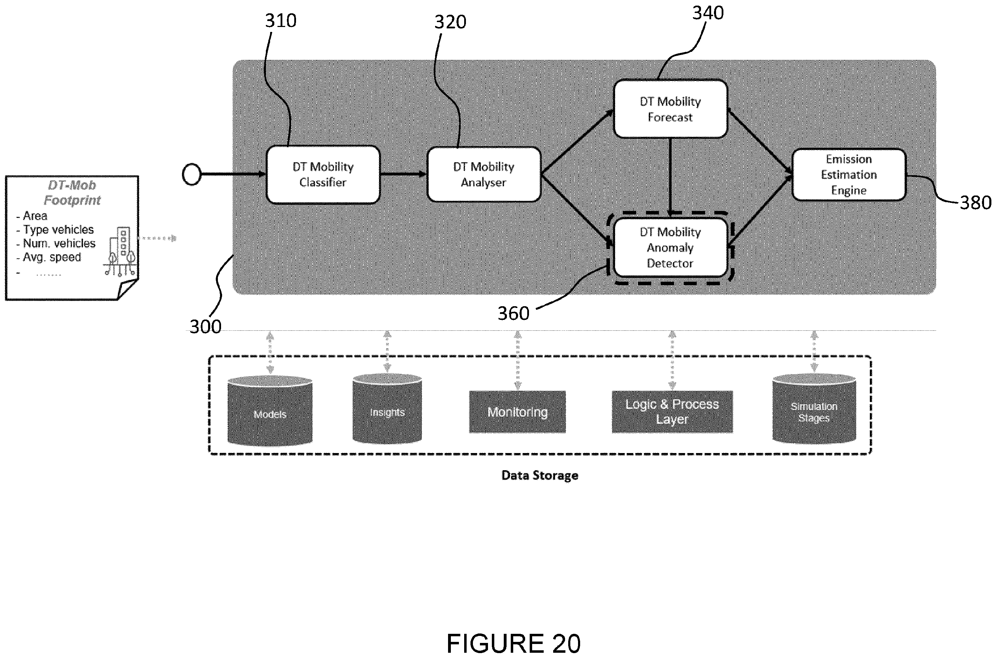

Figure 19 is a diagram illustrating the system 300 according to an implementation example. Figure 20 is a diagram illustrating the system 300 as well as some inputs/communication features. The DT-Mob footprint represents data that may be received from a digital twin of a geographical area and may include any of vehicles counts, types of vehicles, speed, average speed, max speed, minimum speed, level of congestion, traffic jams (number of), level of use of the road network, max transit capacity, etc.

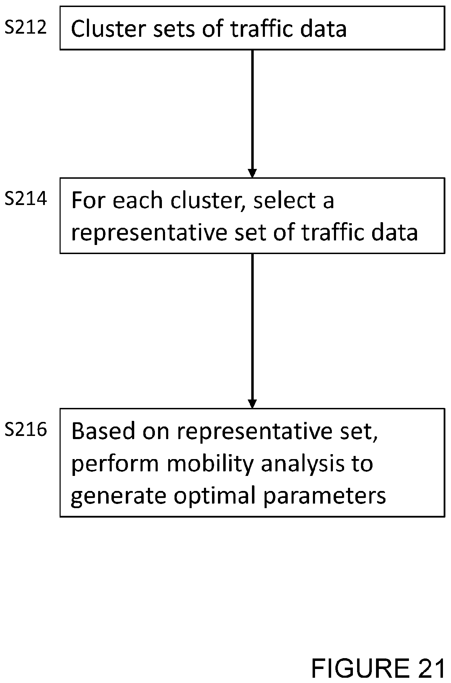

Figure 21 is a diagram illustrating a method. Step S212 comprises clustering sets of traffic data. Each set of traffic data is traffic data corresponding to a geographical region. The traffic data may be as described herein e.g., in the first implementation.

Step S214 comprises selecting a representative set of traffic data for each cluster.

Step S216 comprises performing mobility analysis on a representative set of traffic data to generate optimal parameters for a seasonal forecast (of the regions corresponding to that representative set of traffic data).

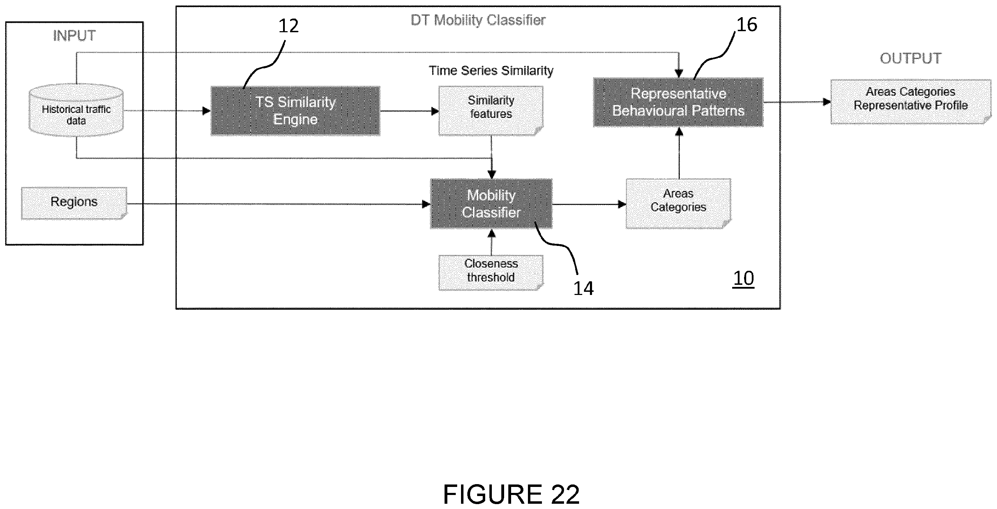

Figure 22 is a diagram illustrating the DT mobility classifier 10 according to an implementation example. The DT mobility classifier 10 may be considered to carry out steps S212 and S214.

As mentioned previously, the DT Mobility Classifier 10 analyses historical and live information (which may be referred to collectively as traffic data), categorises regions based on their mobility behavioural patterns, and selects a number of representative regions/behavioural patterns that represent the behaviour of all the regions. The mobility behavioural pattern can be analysed from different angles, i.e., based on different aspects including vehicles counts, average speeds, maximum-minimum speed, level of congestion, traffic jams (number of), level of use of the road network, max transit capacity, etc. Vehicle counts and (average) speed may be preferred in some examples (for example because these aspects may be used to compute emissions.

The DT Mobility Classifier 10 receives as inputs the historical traffic data and the information of the regions managed by the DT (which may be referred to together as traffic data). As shown in Figure 22 the DT Mobility Classifier 10 in a specific implementation example comprises three components: the TS Similarity Engine 12, the Mobility Classifier 14, and the Representative Behavioural Patterns module 16.

As outputs, the DT Mobility Classifier 10 may provide: (1) a set of categories/clusters into which the regions (e.g., those managed by the relevant DT solution) are classified, and (2) a set of representative profiles (representative behaviours/behavioural patterns or representative sets of traffic data) that represent each category/cluster.

## TS Similarity Engine 12

The TS Similarity Engine 12 analyses the historical mobility data (i.e., the traffic data) for all the regions and provides similarity features among all the regions. The TS similarity engine 12 analyses the traffic data and determines an average behaviour for each region. Then the TS similarity engine 12 performs a similarity search and provides a set of similarity features to be used by the Mobility Classifier 14. The similarity features are a set of metrics that determine how similar two time series are, i.e., difference (positive and negative) values of the time series with respect to the time. The similarity features may include a difference based on vector compositions, or even based on one or more patterns in the time series.

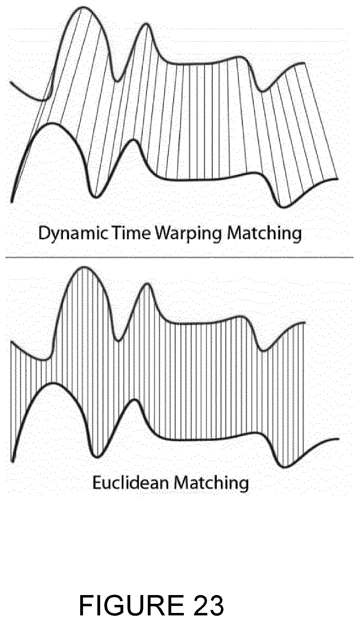

Figure 23 illustrates two techniques which may be used to generate the similarity features: DTW looks for the closest values within a range of time, while Euclidean looks for the similarity for each concrete value during that time.

Mobility Classifier 14

The Mobility Classifier 14 uses as inputs the information from all the regions (e.g., those managed by the DT) and the historical mobility data (which may be referred to together as traffic data), together with the similarity features provided by the TS Similarity Engine 12. Additionally, the Mobility Classifier 14 may receive a parameter defining the number of categories and/or an "acceptable" error. This parameter may take the form of a "closeness" threshold which defines how similar the sets of traffic data must be to be clustered in the same category.

For the generation of the different categories (the clustering), the Mobility Classifier 14 performs the following algorithm:

$$\min_{\mu} \sum_{x \in D} DTW(\mu, x)^2$$

where:

$\mu$ - Centroid.
$x$ - Average behaviour of a region (may be representative of a set of values).
$DTW(x, y)$ - Similarity measure between $x$ and $y$ (Dynamic Time Warping).

Defined as:

$$DTW(x, y) = \min_{\pi} \sqrt{\sum_{(i,j) \in \pi} d(x_i, y_j)^2}$$

where:
$d(x_i, y_j)$ - Distance between $x$ and $y$.

Dynamic time warping is used to compute the similarity here, but other techniques may be used, for example Euclidean distance, vector space similarity, shapelets similarity, bag of features/patterns, etc.

After performing the algorithm, the Mobility Classifier 14 provides the different categories generated and information regarding which category each region belongs to.

Representative Behavioural Patterns module 16

The Representative Behavioural Patterns module 16 provides, for each category, a set of traffic data which is closest to the centroid for that cluster/category (the centroid corresponding to the "average behaviour" for the cluster/category). The Representative Behavioural Patterns module 16 uses as input the historical traffic data (i.e., traffic data/sets of traffic data) and information of the categories as well as information regarding which category each region belongs to.

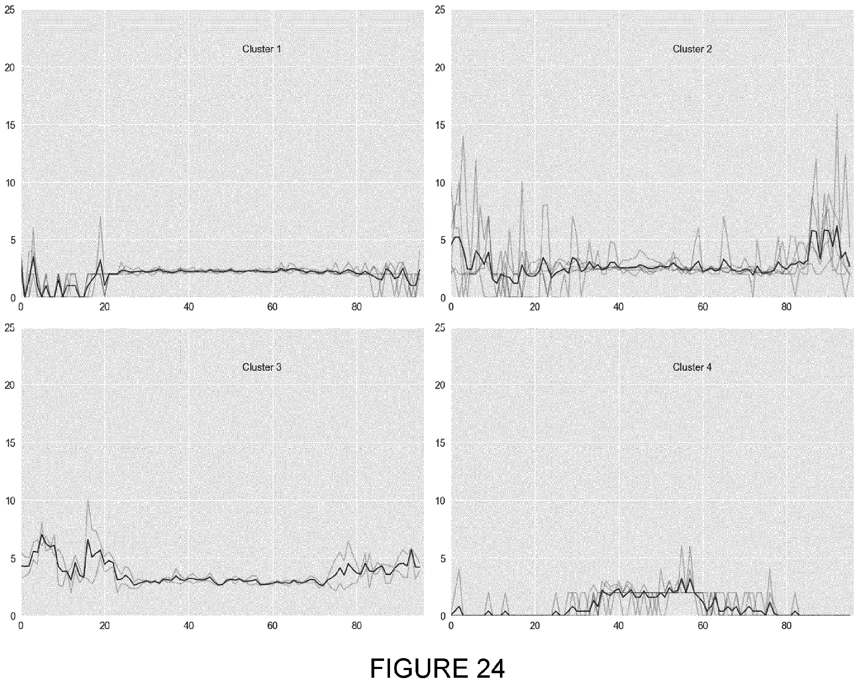

Figure 24 illustrates, for a number of clusters, traffic data. Where the cluster comprises a number of regions, Figure 24 illustrates a representative set of historical data or "representative behavioural pattern" (using a darker line) and the other sets of traffic data corresponding to the other region(s) in the cluster (using lighter-shaded lines). As can be seen in Figure 24, there exist some categories that aggregate a large number of behavioural patterns, or regions, and other categories that only have few of them, or even only one. Such specific details will vary from example to example and may depend at least in part on a closeness threshold or other parameter defining the number of categories or "acceptable" error.

Finally, the Representative Behavioural Patterns or representative sets of traffic data for the clusters are provided to the DT mobility analyser 320 and may also be provided to the forecasting and anomaly detection modules 340, 360. The classification/clustering of the sets of traffic data for the plurality of regions and the selection of representative sets of traffic data facilitate improved efficiency, particularly when managing a large number of regions, and facilitates scalability, both while maintaining a high level of accuracy.

For each region that the DT mobility analyser 320 analyses, the DT mobility analyser 320 uses the representative set of traffic data of the cluster/category of that region (rather than the actual traffic data of the region) to determine the optimal parameters. Otherwise, the DT mobility analyser 320 may operate in the same way as described with respect to the first implementation and duplicate description is omitted.

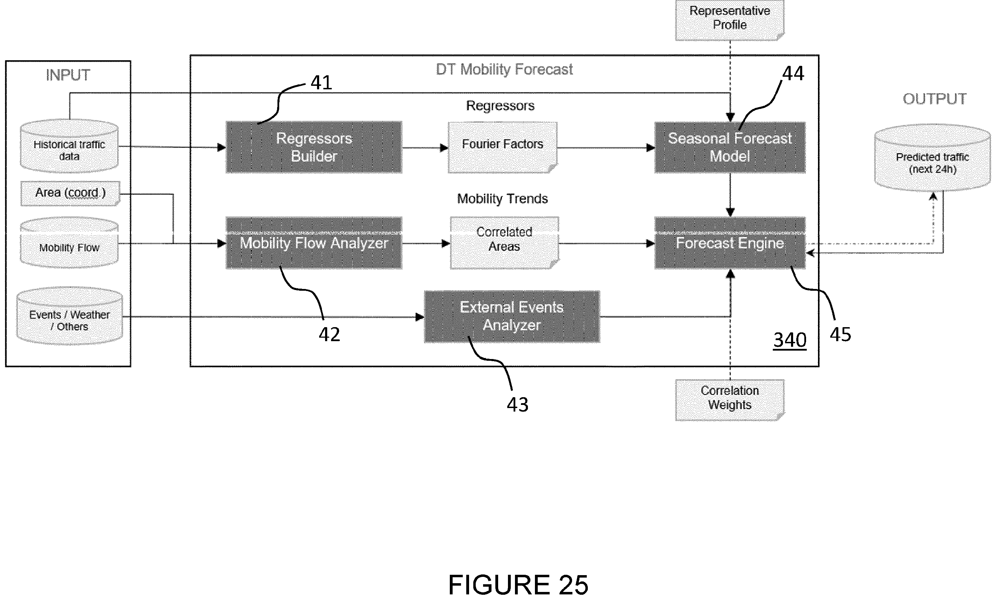

The DT mobility forecast module 340 (specifically, the seasonal forecast model module 44) uses the optimal parameters provided by the DT mobility analyser 320, and otherwise it's operation may be the same as described with respect to the first implementation. Figure 25 illustrates the DT mobility forecast module 340 and shows that the seasonal forecast model module 44 receives "representative profile" to indicate that this module 44 receives the optimal parameters from the DT mobility analyser 320 based on a representative set of traffic data. Aside from the optimal parameters, the seasonal forecast model module 44 and the DT mobility forecast model 340 in general may use the actual data of the region concerned (i.e., and not a representative profile).

The second implementation further includes a method comprising the method described with respect to Figure 21 and the method described with respect to Figure 6 and/or Figure 5. For example, the method described with respect to Figure 21 may be carried out as a method step S21 in the method described with respect to Figure 6. In this case the seasonal traffic forecasts may utilize optimal parameters determined based on representative sets of data corresponding to the regions under consideration rather than the actual traffic data of the regions themselves. As mentioned above, apart from the optimal parameter determination, the forecasting in general may use the actual traffic data of the region concerns, i.e., and not a representative set of traffic data.

In a similar way, aspects of the first implementation may comprise aspects or parts thereof of the second implementation.

In some aspects, the second implementation may not include the DT anomaly detector 360 or method steps which may be performed by the DT anomaly detector 360 (which is illustrated by this module being outlined with a dashed line in Figures 18-20.

In some aspects of the first or second implementations generating a traffic forecast may be simplified compared to the traffic forecast generation described above and the adjustment of a forecast for a target region based on at least one other forecast of at least one other region may not be carried out.

The traffic data of the first and second implementations is time series data.

Aspects disclosed herein in the first and second implementations improve forecasted and simulated scenarios with respect to traffic mobility. Emissions prediction/estimation is provided. Aspects disclosed herein may also improve forecasted and simulated scenarios with respect to human mobility. A geographical area comprising the geographical regions may be an urban area, e.g., a town or city.

Some benefits of the aspects disclosed herein include the following:

- Scalable Seasonal Forecast - maintain precision on the forecasted values as well as anomalies with large seasonal scope and small granularity (1 year / 5-15 min. granularity).
- Context-aware forecast and anomaly detection at different levels, key for simulations and digital rehearsals
- Detection of abnormal behaviors with a better accuracy than other approaches by being seasonal- and trend-agnostic.
- High-Demand Responses. Near real-time responses on demand for high frequency systems (2-5 secs), such as DT solutions. Reduced time for incremental training.
- Complexity Reduction, space reduction. Minimize the size of the models as well as their complexity for being suitable in Digital Twin environments.
- Suitability to Large-Scale Executions. Facilitates minimizing the needs on time, size and computational resources when Forecast and/or Anomaly Detection models needs to scale-up.
- Complexity Reduction for minimizing the number of the models as well as their complexity for being suitable in Digital Twin environments while maintaining high precision.

Aspects disclosed herein may include any of

- DT Mobility Forecast - Mechanism for predicting near future behaviour of mobility considering specific features critical for a DT solution, such as, seasonality in a large period with small granularity, promptness in the forecast, minimised models, mobility flow analysis and context-aware prediction at different levels - critical for digital rehearsals, and complex pattern-aware (events, correlated areas, weather, and others).
- DT Mobility Anomaly Detector - Process for detecting anomalies in traffic and pollution agnostic to seasonal and trend aspects from expected behaviour against forecasted.
- DT Mobility Classifier - Mechanism for increasing the capability of managing large scale scenarios for forecasting pollutant emissions and potential behavioural anomalies in traffic for Digital Twin solutions. This component minimizes the computational requirements and the models needed to scale-up while maintaining the precision and the promptness in the responses critical for real-time environments.

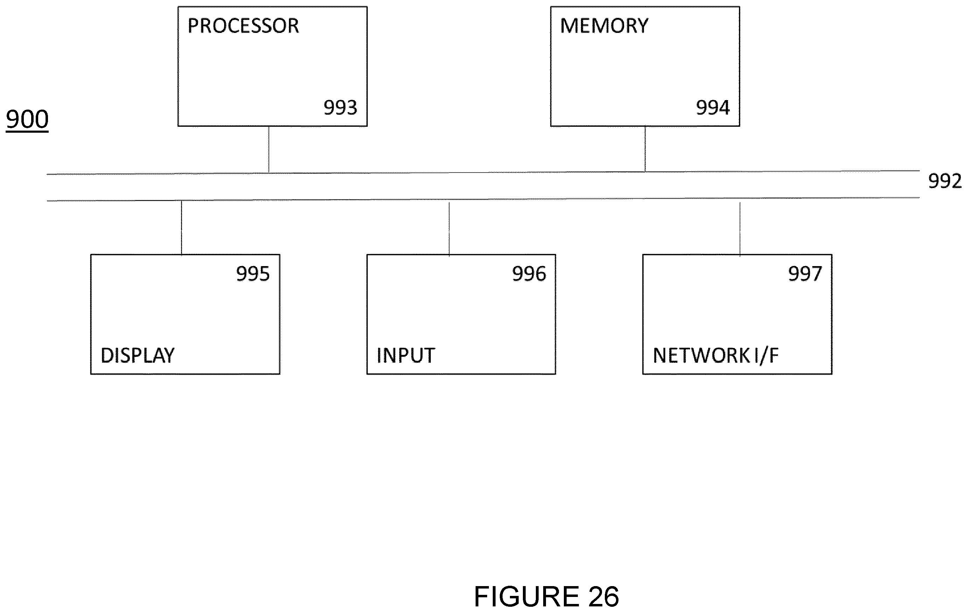

Figure 26 is a block diagram of an information processing apparatus 900 or a computing device 900, such as a data storage server, which embodies the present invention, and which may be used to implement some or all of the operations of a method embodying the present invention and perform some or all of the tasks of apparatus of an embodiment. Figure 26 and its description is relevant to/applies to the first implementation and the second implementation.

The computing device 900 may be used to implement any of the method steps described above, e.g., any of steps S20-S100, S22-S28, S101, S212-S216.

The computing device 900 comprises a processor 993 and memory 994. Optionally, the computing device also includes a network interface 997 for communication with other such computing devices, for example with other computing devices of invention embodiments. Optionally, the computing device also includes one or more input mechanisms such as keyboard and mouse 996, and a display unit such as one or more monitors 995. These elements may facilitate user interaction. The components are connectable to one another via a bus 992.

The memory 994 may include a computer readable medium, which term may refer to a single medium or multiple media (e.g., a centralized or distributed database and/or associated caches and servers) configured to carry computer-executable instructions. Computer-executable instructions may include, for example, instructions and data accessible by and causing a computer (e.g., one or more processors) to perform one or more functions or operations. For example, the computer-executable instructions may include those instructions for implementing a method disclosed herein, or any method steps disclosed herein, for example any of steps S20-S100, S22-S28, S101, S212-S216. Thus, the term "computer-readable storage medium" may also include any medium that is capable of storing, encoding, or carrying a set of instructions for execution by the machine and that cause the machine to perform any one or more of the method steps of the present disclosure. The term "computer-readable storage medium" may accordingly be taken to include, but not be limited to, solid-state memories, optical media, and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing computer program code stored in the memory 994 to implement any of the method steps described herein. The memory 994 stores data being read and written by the processor 993 and may store traffic data and/or mobility information and/or mobility flow information and/or coefficients/parameters and/or forecasts and/or forecast information and/or external events information/data and/or region information and/or correlation information and/or category information and/or thresholds and/or similarity information and/or equations/algorithms and/or input data and/or other data, described above, and/or programs for executing any of the method steps described above. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and operations discussed herein. The processor 993 may be considered to comprise any of the modules described above. Any operations described as being implemented by a module may be implemented as a method by a computer and e.g., by the processor 993.

The display unit 995 may display a representation of data stored by the computing device, such as a representation of traffic data and/or mobility information and/or mobility flow information and/or coefficients/parameters and/or forecasts and/or forecast information and/or external events information/data and/or region information and/or correlation information and/or category information and/or thresholds and/or similarity information and/or equations/algorithms and/or input data and/or other data and/or GUI windows and/or interactive representations enabling a user to interact with the apparatus 900 by e.g. drag and drop or selection interaction, and/or any other output described above, and may also display a cursor and dialog boxes and screens enabling interaction between a user and the programs and data stored on the computing device. The input mechanisms 996 may enable a user to input data and instructions to the computing device, such as enabling a user to input any user input described above.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball, etc. may be included in the computing device.

Methods embodying the present invention may be carried out on a computing device/apparatus 900 such as that illustrated in Figure 26. Such a computing device need not have every component illustrated in Figure 26, and may be composed of a subset of those components. For example, the apparatus 900 may comprise the processor 993 and the memory 994 connected to the processor 993. Or the apparatus 900 may comprise the processor 993, the memory 994 connected to the processor 993, and the display 995. A method embodying the present invention may be carried out by a single computing device in communication with one or more data storage servers via a network. The computing device may be a data storage itself storing at least a portion of the data.

A method embodying the present invention may be carried out by a plurality of computing devices operating in cooperation with one another. One or more of the plurality of computing devices may be a data storage server storing at least a portion of the data.

The invention may be implemented in digital electronic circuitry, or in computer hardware, firmware, software, or in combinations of them. The invention may be implemented as a computer program or computer program product, i.e., a computer program tangibly embodied in a non-transitory information carrier, e.g., in a machine-readable storage device, or in a propagated signal, for execution by, or to control the operation of, one or more hardware modules.

A computer program may be in the form of a stand-alone program, a computer program portion or more than one computer program and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random-access memory or both. The essential elements of a computer are a processor for executing instructions coupled to one or more memory devices for storing instructions and data.

The above-described embodiments of the present invention may advantageously be used independently of any other of the embodiments or in any feasible combination with one or more others of the embodiments. For example, features and/or aspects of the first/second implementation may be incorporated into the other of the first/second implementation.

## Claims

1. A computer-implemented method comprising:

    based on a plurality of sets of traffic data of a plurality of geographical regions, respectively, performing a parameter determination process comprising:

        clustering (S212) the sets of traffic data based on similarity to each other to generate a plurality of clusters of the sets of traffic data;
        for each cluster comprising a plurality of sets of traffic data, selecting (S214) as a representative set of traffic data the set of traffic data of the cluster which is most similar to an average of the sets of traffic data of the cluster; and
        based on a representative set of traffic data corresponding to a target geographical region, performing (S216) mobility analysis to determine parameters for a seasonal traffic forecast for the target geographical region and, based on at least one representative set of traffic data corresponding to at least one other geographical region, performing mobility analysis to determine parameters for at least one other seasonal traffic forecast for the at least one other geographical region;

    performing a traffic forecasting process for the target geographical region using the set of traffic data of the target geographical region and the at least one set of traffic data for the at least one other geographical region, the traffic forecasting process comprising:

        based on the set of traffic data of the target geographical region, and using the determined parameters for the seasonal traffic forecast for the target geographical region, generating (S22) the seasonal traffic forecast for the target geographical region;

based on the at least one set of traffic data of the at least one other geographical region, and using the determined parameters for the at least one other seasonal traffic forecast for the at least one other geographical region, generating (S24) the at least one other seasonal traffic forecast for the at least one other geographical region;

based on the set of traffic data of the geographical region and the at least one set of traffic data of the at least one other geographical region, analyzing (S26) a mobility flow of the geographical area to determine at least one correlation between the traffic data of the target geographical region and the traffic data of the at least one other geographical region; and

generating (S28) a combined traffic forecast by adjusting the seasonal forecast for the target geographical region based on the at least one other seasonal forecast and the determined at least one correlation; and

predicting (S101) emissions produced by traffic in the target geographical region based on the combined traffic forecast,

wherein the traffic data comprises data obtained from sensors in the geographical region concerned,

wherein the traffic data of said geographical region comprises

a number of vehicles inside the geographical region or a number of each of a plurality of types of vehicles inside the geographical region; and

an average speed of each of a plurality of vehicles inside the geographical region,

wherein performing the mobility analysis based on said representative set of traffic data to determine the parameters comprises:

obtaining levels of stationarity of a yearly trend in said representative set of traffic data and determining stationary parameters; and/or

obtaining relations among data of different time periods in said representative set of traffic data and determining regression parameters; and/or

obtaining a range of values in which a mobility trend in said representative set of traffic data oscillates and determining predictor parameters,

wherein estimating (S101) the emissions comprises computing an emissions amount based on:

information indicating average emissions of a vehicle based on the speed;

the number of vehicles from the traffic forecast; and

the average speed of vehicles from the traffic forecast.

2. The computer-implemented method as claimed in claim 1, wherein clustering the sets of traffic data based on similarity to each other comprises clustering the sets of traffic data based on at least one aspect of the traffic data, the at least one aspect comprising any of:

a number of vehicles inside the geographical region;

a number of each of a plurality of types of vehicles inside the geographical region;

a location of each of a plurality of vehicles inside the geographical region;

a direction of travel of each of a plurality of vehicles inside the geographical region;

a speed of each of a plurality of vehicles inside the geographical region;

an average speed of each of a plurality of vehicles inside the geographical region;

a minimum and/or maximum speed of each of a plurality of vehicles inside the geographical region;

a level of congestion inside the geographical region;

a number of traffic jams inside the geographical region;

a level of use of a road network inside the geographical region; and

a maximum transit capacity inside the geographical region.

3. The computer-implemented method as claimed in claim 1 or claim 2, wherein clustering the sets of traffic data based on similarity to each other comprises using dynamic time warping matching or Euclidean matching between the sets of traffic data or between the behavioral representations.

4. The computer-implemented method as claimed in any of the preceding claims, wherein the traffic data comprises data obtained from a digital twin of the geographical region concerned.

5. The computer-implemented method as claimed in any of the preceding claims, wherein the target geographical region and the at least one other geographical region are respective regions of an urban area or a town or city.

6. The computer-implemented method as claimed in any of the preceding claims, wherein generating the seasonal traffic forecast of the target geographical region comprises generating, based on the traffic data concerned, regressors that define a seasonal aspect of the data.

7. The computer-implemented method as claimed in any of the preceding claims, wherein the traffic forecasting process comprises analyzing the mobility flow of the target geographical region and a plurality of other geographical regions to determine the at least one other geographical region relevant for the traffic forecast of the target geographical region.

8. The computer-implemented method as claimed in any of the preceding claims, wherein the traffic data comprises information about events occurring in the geographical region concerned, and wherein the traffic forecasting process further comprises analyzing the traffic data of the target region to obtain at least one correlation between traffic data and at least one event, and wherein generating a traffic forecast by adjusting the seasonal forecast for the target geographical region based on the at least one other seasonal forecast and the determined correlation further comprises adjusting the seasonal forecast for the target geographical region based on the at least one correlation between traffic data and at least one external event and based on a predicted at least one event.

9. The computer-implemented method as claimed in any of the preceding claims, wherein the set of traffic data of the target geographical region and the at least one set of traffic data for the at least one other geographical region comprise traffic data over a first time period and the combined traffic forecast is a first traffic forecast,

wherein the computer-implemented method further comprises generating a second traffic forecast by performing the traffic forecasting process using traffic data over a second time period,
wherein the first time period comprises the second time period and an additional time period more recent than the second time period,
wherein the computer-implemented method comprises:

decomposing the first traffic forecast into first seasonal, trend, and noise components and decomposing the second traffic forecast into second seasonal, trend, and noise components; and
comparing the first noise component of the first traffic forecast with the second noise component of the second traffic forecast to detect at least one anomaly, comprising comparing at least one deviation between the first and second traffic forecasts to an anomaly threshold,

and wherein predicting emissions produced by traffic in the target geographical region includes, when at least one anomaly has been detected, predicting the impact on the emissions of the at least one detected anomaly.

10. A computer-implemented method comprising performing the computer-implemented method according to any of the preceding claims a plurality of times with a different geographical region of the geographical area as the target region each time.

11. A computer program which, when run on a computer, causes the computer to carry out a method comprising:

based on a plurality of sets of traffic data of a plurality of geographical regions, respectively, performing a parameter determination process comprising:

clustering (S212) the sets of traffic data based on similarity to each other to generate a plurality of clusters of the sets of traffic data;
for each cluster comprising a plurality of sets of traffic data, selecting (S214) as a representative set of traffic data the set of traffic data of the cluster which is most similar to an average of the sets of traffic data of the cluster; and
based on a representative set of traffic data corresponding to a target geographical region, performing (S216) mobility analysis to determine parameters for a seasonal traffic forecast for the target geographical region and, based on at least one representative set of traffic data corresponding to at least one other geographical region, performing mobility analysis to determine parameters for at least one other seasonal traffic forecast for the at least one other geographical region;

performing a traffic forecasting process for the target geographical region using the set of traffic data of the target geographical region and the at least one set of traffic data for the at least one other geographical region, the traffic forecasting process comprising:

based on the set of traffic data of the target geographical region, and using the determined parameters for the seasonal traffic forecast for the target geographical region, generating (S22) the seasonal traffic forecast for the target geographical region;

based on the at least one set of traffic data of the at least one other geographical region, and using the determined parameters for the at least one other seasonal traffic forecast for the at least one other geographical region, generating (S24) the at least one other seasonal traffic forecast for the at least one other geographical region;

based on the set of traffic data of the geographical region and the at least one set of traffic data of the at least one other geographical region, analyzing (S26) a mobility flow of the geographical area to determine at least one correlation between the traffic data of the target geographical region and the traffic data of the at least one other geographical region; and

generating (S28) a combined traffic forecast by adjusting the seasonal forecast for the target geographical region based on the at least one other seasonal forecast and the determined at least one correlation; and

predicting (S101) emissions produced by traffic in the target geographical region based on the combined traffic forecast,

wherein the traffic data comprises data obtained from sensors in the geographical region concerned,

wherein the traffic data of said geographical region comprises

a number of vehicles inside the geographical region or a number of each of a plurality of types of vehicles inside the geographical region; and

an average speed of each of a plurality of vehicles inside the geographical region,

wherein performing the mobility analysis based on said representative set of traffic data to determine the parameters comprises:

obtaining levels of stationarity of a yearly trend in said representative set of traffic data and determining stationary parameters; and/or

obtaining relations among data of different time periods in said representative set of traffic data and determining regression parameters; and/or

obtaining a range of values in which a mobility trend in said representative set of traffic data oscillates and determining predictor parameters,

wherein estimating (S101) the emissions comprises computing an emissions amount based on:

information indicating average emissions of a vehicle based on the speed;

the number of vehicles from the traffic forecast; and

the average speed of vehicles from the traffic forecast.

12. An information processing apparatus (900) comprising a memory (994) and a processor (993) connected to the memory (994), wherein the processor (993) is configured to:

based on a plurality of sets of traffic data of a plurality of geographical regions, respectively, perform a parameter determination process comprising:

clustering the sets of traffic data based on similarity to each other to generate a plurality of clusters of the sets of traffic data;

for each cluster comprising a plurality of sets of traffic data, selecting as a representative set of traffic data the set of traffic data of the cluster which is most similar to an average of the sets of traffic data of the cluster; and

based on a representative set of traffic data corresponding to a target geographical region, performing mobility analysis to determine parameters for a seasonal traffic forecast for the target geographical region and, based on at least one representative set of traffic data corresponding to at least one other geographical region, performing mobility analysis to determine parameters for at least one other seasonal traffic forecast for the at least one other geographical region;

perform a traffic forecasting process for the target geographical region using the set of traffic data of the target geographical region and the at least one set of traffic data for the at least one other geographical region, the traffic forecasting process comprising:

based on the set of traffic data of the target geographical region, and using the determined parameters for the seasonal traffic forecast for the target geographical region, generating the seasonal traffic forecast for the target geographical region;

based on the at least one set of traffic data of the at least one other geographical region, and using the determined parameters for the at least one other seasonal traffic forecast for the at least one other geographical region, generating the at least one other seasonal traffic forecast for the at least one other geographical region;

based on the set of traffic data of the geographical region and the at least one set of traffic data of the at least one other geographical region, analyzing a mobility flow of the geographical area to determine at least one correlation between the traffic data of the target geographical region and the traffic data of the at least one other geographical region; and

generating a combined traffic forecast by adjusting the seasonal forecast for the target geographical region based on the at least one other seasonal forecast and the determined at least one correlation; and

predict emissions produced by traffic in the target geographical region based on the combined traffic forecast, wherein the traffic data comprises data obtained from sensors in the geographical region concerned, wherein the traffic data of said geographical region comprises:

a number of vehicles inside the geographical region or a number of each of a plurality of types of vehicles inside the geographical region; and

an average speed of each of a plurality of vehicles inside the geographical region,

wherein performing the mobility analysis based on said representative set of traffic data to determine the parameters comprises:

obtaining levels of stationarity of a yearly trend in said representative set of traffic data and determining stationary parameters; and/or

obtaining relations among data of different time periods in said representative set of traffic data and determining regression parameters; and/or

obtaining a range of values in which a mobility trend in said representative set of traffic data oscillates and determining predictor parameters,

wherein estimating the emissions comprises computing an emissions amount based on:

information indicating average emissions of a vehicle based on the speed;
the number of vehicles from the traffic forecast; and
the average speed of vehicles from the traffic forecast.

**Patentansprüche**

1. Computerimplementiertes Verfahren, umfassend:
   basierend auf einer Vielzahl von Sätzen von Verkehrsdaten aus einer Vielzahl von geografischen Regionen, jeweiliges Durchführen eines Parameterbestimmungsprozesses, umfassend:

   Clustern (S212) der Sätze von Verkehrsdaten basierend auf Ähnlichkeit zueinander, um eine Vielzahl von Clustern der Sätze von Verkehrsdaten zu erzeugen;
   für jeden Cluster, umfassend eine Vielzahl von Sätzen von Verkehrsdaten, Auswählen (S214) eines Satzes von Verkehrsdaten des Clusters, der einem Durchschnitt der Sätze von Verkehrsdaten des Clusters am ähnlichsten ist, als repräsentativen Satz von Verkehrsdaten; und
   basierend auf einem repräsentativen Satz von Verkehrsdaten, die einer geografischen Zielregion entsprechen, Durchführen (S216) einer Mobilitätsanalyse, um Parameter für eine saisonale Verkehrsprognose für die geografische Zielregion zu bestimmen, und basierend auf mindestens einem repräsentativen Satz von Verkehrsdaten, die mindestens einer anderen geografischen Region entsprechen, Durchführen einer Mobilitätsanalyse, um Parameter für mindestens eine andere saisonale Verkehrsprognose für die mindestens eine anderen geografische Region zu bestimmen;

Durchführen eines Verkehrsprognoseprozesses für die geografische Zielregion unter Verwendung des Satzes von Verkehrsdaten der geografischen Zielregion und des mindestens einen Satzes von Verkehrsdaten für die mindestens eine andere geografische Region, wobei der Verkehrsprognoseprozess Folgendes umfasst:

basierend auf dem Satz von Verkehrsdaten der geografischen Zielregion und unter Verwendung der bestimmten Parameter für die saisonale Verkehrsprognose für die geografische Zielregion, Erzeugen (S22) der saisonalen Verkehrsprognose für die geografische Zielregion;

basierend auf dem mindestens einen Satz von Verkehrsdaten der mindestens einen anderen geografischen Region und unter Verwendung der bestimmten Parameter für die mindestens eine andere saisonale Verkehrsprognose für die mindestens eine andere geografische Region, Erzeugen (S24) der mindestens einen anderen saisonalen Verkehrsprognose für die mindestens eine andere geografische Region;

basierend auf dem Satz von Verkehrsdaten der geografischen Region und dem mindestens einen Satz von Verkehrsdaten der mindestens einen anderen geografischen Region, Analysieren (S26) eines Mobilitätsflusses des geografischen Gebiets, um mindestens eine Korrelation zwischen den Verkehrsdaten der geografischen Zielregion und den Verkehrsdaten der mindestens einen anderen geografischen Region zu bestimmen; und

Erzeugen (S28) einer kombinierten Verkehrsprognose durch Anpassen der saisonalen Prognose für die geografische Zielregion basierend auf der mindestens einen anderen saisonalen Prognose und der bestimmten mindestens einen Korrelation; und

Vorhersagen (S101) von Emissionen, die durch den Verkehr in der geografischen Zielregion produziert werden, basierend auf der kombinierten Verkehrsprognose,

wobei die Verkehrsdaten Daten umfassen, die von Sensoren in der betroffenen geografischen Region erlangt wurden,

wobei die Verkehrsdaten der geografischen Region Folgendes umfassen:

eine Anzahl von Fahrzeugen innerhalb der geografischen Region oder eine Anzahl jeder einer Vielzahl von Fahrzeugtypen innerhalb der geografischen Region; und

eine Durchschnittsgeschwindigkeit jedes einer Vielzahl von Fahrzeugen innerhalb der geografischen Region,

wobei Durchführen der Mobilitätsanalyse basierend auf dem repräsentativen Satz von Verkehrsdaten, um die Parameter zu bestimmen, Folgendes umfasst:

Erlangen von Stationaritätsgraden eines jährlichen Trends in dem repräsentativen Satz von Verkehrsdaten und Bestimmen von Stationaritätsparametern; und/oder

Erlangen von Beziehungen zwischen Daten verschiedener Zeiträume in dem repräsentativen Satz von Verkehrsdaten und Bestimmen von Regressionsparametern; und/oder

Erlangen eines Wertebereichs, in welchem ein Mobilitätstrend in dem repräsentativen Satz von Verkehrsdaten schwankt, und Bestimmen von Vorhersageparametern,

wobei Schätzen (S101) der Emissionen Berechnen einer Emissionsmenge umfasst, basierend auf:

Informationen, die die durchschnittlichen Emissionen eines Fahrzeugs basierend auf der Geschwindigkeit angeben;

der Anzahl der Fahrzeuge aus der Verkehrsprognose; und

der Durchschnittsgeschwindigkeit der Fahrzeuge aus der Verkehrsprognose.

2. Computerimplementiertes Verfahren nach Anspruch 1, wobei Clustern der Sätze von Verkehrsdaten basierend auf Ähnlichkeit zueinander das Clustern der Sätze von Verkehrsdaten basierend auf mindestens einem Aspekt der Verkehrsdaten umfasst, wobei der mindestens eine Aspekt mindestens eines der Folgenden umfasst:

eine Anzahl von Fahrzeugen innerhalb der geografischen Region;

eine Anzahl jedes einer Vielzahl von Fahrzeugtypen innerhalb der geografischen Region;

eine Position jedes einer Vielzahl von Fahrzeugen innerhalb der geografischen Region;

eine Fahrtrichtung jedes einer Vielzahl von Fahrzeugen innerhalb der geografischen Region;

eine Geschwindigkeit jedes einer Vielzahl von Fahrzeugen innerhalb der geografischen Region;

eine Durchschnittsgeschwindigkeit jedes einer Vielzahl von Fahrzeugen innerhalb der geografischen Region;

eine Mindest- und/oder Höchstgeschwindigkeit jedes einer Vielzahl von Fahrzeugen innerhalb der geografischen Region;

einen Stauauslastungsgrad innerhalb der geografischen Region;

eine Anzahl von Verkehrsstaus innerhalb der geografischen Region;

einen Nutzungsgrad eines Straßennetzes innerhalb der geografischen Region; und

eine maximale Durchfahrtskapazität innerhalb der geografischen Region.

3. Computerimplementiertes Verfahren nach Anspruch 1 oder Anspruch 2, wobei das Clustern der Verkehrsdatenmengen basierend auf Ähnlichkeit zueinander das Verwenden von dynamischem Zeitverzerrungsabgleich oder euklidischem Abgleich zwischen den Sätzen von Verkehrsdaten oder zwischen den Verhaltensdarstellungen umfasst.

4. Computerimplementiertes Verfahren nach einem der vorhergehenden Ansprüche, wobei die Verkehrsdaten Daten umfassen, die von einem digitalen Zwilling der betroffenen geografischen Region erlangt wurden.

5. Computerimplementiertes Verfahren nach einem der vorhergehenden Ansprüche, wobei die geografische Zielregion und die mindestens eine andere geografische Region jeweilige Regionen eines Stadtgebiets oder einer Kleinstadt oder Großstadt sind.

6. Computerimplementiertes Verfahren nach einem der vorhergehenden Ansprüche, wobei das Erzeugen der saisonalen Verkehrsprognose für die geografische Zielregion das Erzeugen von Regressoren umfasst, die einen saisonalen Aspekt der Daten definieren, basierend auf den betroffenen Verkehrsdaten.

7. Computerimplementiertes Verfahren nach einem der vorhergehenden Ansprüche, wobei der Verkehrsprognoseprozess Analysieren des Mobilitätsflusses der geografischen Zielregion und einer Vielzahl anderer geografischer Regionen umfasst, um mindestens eine andere geografische Region zu bestimmen, die für die Verkehrsprognose der geografischen Zielregion relevant ist.

8. Computerimplementiertes Verfahren nach einem der vorhergehenden Ansprüche, wobei die Verkehrsdaten Informationen über Ereignisse umfassen, die in der betroffenen geografischen Region auftreten, und wobei der Verkehrsprognoseprozess ferner Analysieren der Verkehrsdaten der Zielregion umfasst, um mindestens eine Korrelation zwischen Verkehrsdaten und mindestens einem Ereignis zu erlangen, und wobei Erzeugen einer Verkehrsprognose durch Anpassen der saisonalen Prognose für die geografische Zielregion basierend auf der mindestens einer anderen saisonalen Prognose und der bestimmten Korrelation ferner Anpassen der saisonalen Prognose für die geografische Zielregion basierend auf der mindestens einen Korrelation zwischen Verkehrsdaten und mindestens einem externen Ereignis und basierend auf einem vorhergesagten mindestens einen Ereignis umfasst.

9. Computerimplementiertes Verfahren nach einem der vorhergehenden Ansprüche, wobei der Satz von Verkehrsdaten der geografischen Zielregion und der mindestens eine Satz von Verkehrsdaten für die mindestens eine andere geografische Region Verkehrsdaten über einen ersten Zeitraum umfassen und die kombinierte Verkehrsprognose eine erste Verkehrsprognose ist, wobei das computerimplementierte Verfahren ferner Erzeugen einer zweiten Verkehrsprognose durch Ausführen des Verkehrsprognoseprozesses unter Verwendung von Verkehrsdaten über einen zweiten Zeitraum umfasst,

wobei der erste Zeitraum den zweiten Zeitraum und einen zusätzlichen Zeitraum umfasst, der jünger als der zweite Zeitraum ist,

wobei das computerimplementierte Verfahren Folgendes umfasst:

Zerlegen der ersten Verkehrsprognose in eine erste saisonale Komponente, eine Trendkomponente und eine Rauschkomponente und Zerlegen der zweiten Verkehrsprognose in eine zweite saisonale Komponente, eine Trendkomponente und eine Rauschkomponente; und

Vergleichen der ersten Rauschkomponente der ersten Verkehrsprognose mit der zweiten Rauschkomponente der zweiten Verkehrsprognose, um mindestens eine Anomalie zu erkennen, wobei mindestens eine Abweichung zwischen der ersten und der zweiten Verkehrsprognose mit einem Anomalieschwellenwert verglichen wird,

und wobei Vorhersagen der durch den Verkehr in der geografischen Zielregion produzierten Emissionen, wenn mindestens eine Anomalie erkannt wurde, Vorhersagen über die Auswirkungen der mindestens einen erkannten Anomalie auf die Emissionen beinhaltet.

10. Computerimplementiertes Verfahren, umfassend Durchführen des computerimplementierten Verfahrens nach einem der vorhergehenden Ansprüche eine Vielzahl von Malen mit jeweils einer anderen geografischen Region des geografischen Gebiets als Zielregion.

11. Computerprogramm, das, wenn es auf einem Computer ausgeführt wird, den Computer veranlasst, ein Verfahren auszuführen, umfassend:
basierend auf einer Vielzahl von Sätzen von Verkehrsdaten aus einer Vielzahl von geografischen Regionen, jeweiliges Durchführen eines Parameterbestimmungsprozesses, umfassend:

Clustern (S212) der Sätze von Verkehrsdaten basierend auf Ähnlichkeit zueinander, um eine Vielzahl von Clustern der Sätze von Verkehrsdaten zu erzeugen;
für jeden Cluster, umfassend eine Vielzahl von Sätzen von Verkehrsdaten, Auswählen (S214) eines Satzes von Verkehrsdaten des Clusters, der einem Durchschnitt der Sätze von Verkehrsdaten des Clusters am ähnlichsten ist, als repräsentativen Satz von Verkehrsdaten; und
basierend auf einem repräsentativen Satz von Verkehrsdaten, die einer geografischen Zielregion entsprechen, Durchführen (S216) einer Mobilitätsanalyse, um Parameter für eine saisonale Verkehrsprognose für die geografische Zielregion zu bestimmen, und basierend auf mindestens einem repräsentativen Satz von Verkehrsdaten, die mindestens einer anderen geografischen Region entsprechen, Durchführen einer Mobilitätsanalyse, um Parameter für mindestens eine andere saisonale Verkehrsprognose für die mindestens eine anderen geografische Region zu bestimmen;
Durchführen eines Verkehrsprognoseprozesses für die geografische Zielregion unter Verwendung des Satzes von Verkehrsdaten der geografischen Zielregion und des mindestens einen Satzes von Verkehrsdaten für die mindestens eine andere geografische Region, wobei der Verkehrsprognoseprozess Folgendes umfasst:

basierend auf dem Satz von Verkehrsdaten der geografischen Zielregion und unter Verwendung der bestimmten Parameter für die saisonale Verkehrsprognose für die geografische Zielregion, Erzeugen (S22) der saisonalen Verkehrsprognose für die geografische Zielregion;
basierend auf dem mindestens einen Satz von Verkehrsdaten der mindestens einen anderen geografischen Region und unter Verwendung der bestimmten Parameter für die mindestens eine andere saisonale Verkehrsprognose für die mindestens eine andere geografische Region, Erzeugen (S24) der mindestens einen anderen saisonalen Verkehrsprognose für die mindestens eine andere geografische Region;
basierend auf dem Satz von Verkehrsdaten der geografischen Region und dem mindestens einen Satz von Verkehrsdaten der mindestens einen anderen geografischen Region, Analysieren (S26) eines Mobilitätsflusses des geografischen Gebiets, um mindestens eine Korrelation zwischen den Verkehrsdaten der geografischen Zielregion und den Verkehrsdaten der mindestens einen anderen geografischen Region zu bestimmen; und
Erzeugen (S28) einer kombinierten Verkehrsprognose durch Anpassen der saisonalen Prognose für die geografische Zielregion basierend auf der mindestens einen anderen saisonalen Prognose und der bestimmten mindestens einen Korrelation; und
Vorhersagen (S101) von Emissionen, die durch den Verkehr in der geografischen Zielregion produziert werden, basierend auf der kombinierten Verkehrsprognose,
wobei die Verkehrsdaten Daten umfassen, die von Sensoren in der betroffenen geografischen Region erlangt wurden,
wobei die Verkehrsdaten der geografischen Region Folgendes umfassen:

eine Anzahl von Fahrzeugen innerhalb der geografischen Region oder eine Anzahl jeder einer Vielzahl von Fahrzeugtypen innerhalb der geografischen Region; und
eine Durchschnittsgeschwindigkeit jedes einer Vielzahl von Fahrzeugen innerhalb der geografischen Region,
wobei Durchführen der Mobilitätsanalyse basierend auf dem repräsentativen Satz von Verkehrsdaten, um die Parameter zu bestimmen, Folgendes umfasst:

Erlangen von Stationaritätsgraden eines jährlichen Trends in dem repräsentativen Satz von Verkehrsdaten und Bestimmen von Stationaritätsparametern; und/oder
Erlangen von Beziehungen zwischen Daten verschiedener Zeiträume in dem repräsentativen Satz von Verkehrsdaten und Bestimmen von Regressionsparametern; und/oder

Erlangen eines Wertebereichs, in welchem ein Mobilitätstrend in dem repräsentativen Satz von Verkehrsdaten schwankt, und Bestimmen von Vorhersageparametern,
wobei Schätzen (S101) der Emissionen Berechnen einer Emissionsmenge umfasst, basierend auf:

Informationen, die die durchschnittlichen Emissionen eines Fahrzeugs basierend auf der Geschwindigkeit angeben;
der Anzahl der Fahrzeuge aus der Verkehrsprognose; und
der Durchschnittsgeschwindigkeit der Fahrzeuge aus der Verkehrsprognose.

12. Informationsverarbeitungseinrichtung (900), umfassend einen Speicher (994) und einen mit dem Speicher (994) verbundenen Prozessor (993), wobei der Prozessor (993) zu Folgendem konfiguriert ist:
basierend auf einer Vielzahl von Sätzen von Verkehrsdaten aus einer Vielzahl von geografischen Regionen, jeweiliges Durchführen eines Parameterbestimmungsprozesses, umfassend:

Clustern der Sätze von Verkehrsdaten basierend auf Ähnlichkeit zueinander, um eine Vielzahl von Clustern der Sätze von Verkehrsdaten zu erzeugen;
für jeden Cluster, umfassend eine Vielzahl von Sätzen von Verkehrsdaten, Auswählen eines Satzes von Verkehrsdaten des Clusters, der einem Durchschnitt der Sätze von Verkehrsdaten des Clusters am ähnlichsten ist, als repräsentativen Satz von Verkehrsdaten; und
basierend auf einem repräsentativen Satz von Verkehrsdaten, die einer geografischen Zielregion entsprechen, Durchführen einer Mobilitätsanalyse, um Parameter für eine saisonale Verkehrsprognose für die geografische Zielregion zu bestimmen, und basierend auf mindestens einem repräsentativen Satz von Verkehrsdaten, die mindestens einer anderen geografischen Region entsprechen, Durchführen einer Mobilitätsanalyse, um Parameter für mindestens eine andere saisonale Verkehrsprognose für die mindestens eine anderen geografische Region zu bestimmen;
Durchführen eines Verkehrsprognoseprozesses für die geografische Zielregion unter Verwendung des Satzes von Verkehrsdaten der geografischen Zielregion und des mindestens einen Satzes von Verkehrsdaten für die mindestens eine andere geografische Region, wobei der Verkehrsprognoseprozess Folgendes umfasst:

basierend auf dem Satz von Verkehrsdaten der geografischen Zielregion und unter Verwendung der bestimmten Parameter für die saisonale Verkehrsprognose für die geografische Zielregion, Erzeugen der saisonalen Verkehrsprognose für die geografische Zielregion;
basierend auf dem mindestens einen Satz von Verkehrsdaten der mindestens einen anderen geografischen Region und unter Verwendung der bestimmten Parameter für die mindestens eine andere saisonale Verkehrsprognose für die mindestens eine andere geografische Region, Erzeugen der mindestens einen anderen saisonalen Verkehrsprognose für die mindestens eine andere geografische Region;
basierend auf dem Satz von Verkehrsdaten der geografischen Region und dem mindestens einen Satz von Verkehrsdaten der mindestens einen anderen geografischen Region, Analysieren eines Mobilitätsflusses des geografischen Gebiets, um mindestens eine Korrelation zwischen den Verkehrsdaten der geografischen Zielregion und den Verkehrsdaten der mindestens einen anderen geografischen Region zu bestimmen; und
Erzeugen einer kombinierten Verkehrsprognose durch Anpassen der saisonalen Prognose für die geografische Zielregion basierend auf der mindestens einen anderen saisonalen Prognose und der bestimmten mindestens einen Korrelation; und
Vorhersagen von Emissionen, die durch den Verkehr in der geografischen Zielregion produziert werden, basierend auf der kombinierten Verkehrsprognose,
wobei die Verkehrsdaten Daten umfassen, die von Sensoren in der betroffenen geografischen Region erlangt wurden,
wobei die Verkehrsdaten der geografischen Region Folgendes umfassen:

eine Anzahl von Fahrzeugen innerhalb der geografischen Region oder eine Anzahl jeder einer Vielzahl von Fahrzeugtypen innerhalb der geografischen Region; und
eine Durchschnittsgeschwindigkeit jedes einer Vielzahl von Fahrzeugen innerhalb der geografischen Region,
wobei Durchführen der Mobilitätsanalyse basierend auf dem repräsentativen Satz von Verkehrsdaten, um die Parameter zu bestimmen, Folgendes umfasst:

Erlangen von Stationaritätsgraden eines jährlichen Trends in dem repräsentativen Satz von Verkehrsdaten und Bestimmen von Stationaritätsparametern; und/oder

Erlangen von Beziehungen zwischen Daten verschiedener Zeiträume in dem repräsentativen Satz von Verkehrsdaten und Bestimmen von Regressionsparametern; und/oder

Erlangen eines Wertebereichs, in welchem ein Mobilitätstrend in dem repräsentativen Satz von Verkehrsdaten schwankt, und Bestimmen von Vorhersageparametern,

wobei Schätzen der Emissionen Berechnen einer Emissionsmenge umfasst, basierend auf:

Informationen, die die durchschnittlichen Emissionen eines Fahrzeugs basierend auf der Geschwindigkeit angeben;

der Anzahl der Fahrzeuge aus der Verkehrsprognose; und

der Durchschnittsgeschwindigkeit der Fahrzeuge aus der Verkehrsprognose.

**Revendications**

1.  Procédé mis en œuvre par ordinateur comprenant :

    sur la base d'une pluralité d'ensembles de données de trafic d'une pluralité de régions géographiques, respectivement, la réalisation d'un processus de détermination de paramètre comprenant :

    le regroupement (S212) des ensembles de données de trafic sur la base de leur similarité les uns par rapport aux autres pour générer une pluralité de groupes des ensembles de données de trafic ;

    pour chaque groupe comprenant une pluralité d'ensembles de données de trafic, la sélection (S214) en tant qu'ensemble représentatif de données de trafic de l'ensemble de données de trafic du groupe qui est le plus similaire à une moyenne des ensembles de données de trafic du groupe ; et

    sur la base d'un ensemble représentatif de données de trafic correspondant à une région géographique cible, la réalisation (S216) d'une analyse de mobilité pour déterminer les paramètres pour une prévision de trafic saisonnière pour la région géographique cible et, sur la base d'au moins un ensemble représentatif de données de trafic correspondant à au moins une autre région géographique, la réalisation d'une analyse de mobilité pour déterminer les paramètres pour au moins une autre prévision de trafic saisonnière pour l'au moins une autre région géographique ;

    la réalisation d'un processus de prévision de trafic pour la région géographique cible à l'aide de l'ensemble de données de trafic de la région géographique cible et de l'au moins un ensemble de données de trafic pour l'au moins une autre région géographique, le processus de prévision de trafic comprenant :

    sur la base de l'ensemble de données de trafic de la région géographique cible, et à l'aide des paramètres déterminés pour la prévision de trafic saisonnière pour la région géographique cible, la génération (S22) de la prévision de trafic saisonnière pour la région géographique cible ;

    sur la base de l'au moins un ensemble de données de trafic de l'au moins une autre région géographique, et à l'aide des paramètres déterminés pour l'au moins une autre prévision de trafic saisonnière pour l'au moins une autre région géographique, la génération (S24) de l'au moins une autre prévision de trafic saisonnière pour l'au moins une autre région géographique ;

    sur la base de l'ensemble de données de trafic de la région géographique et de l'au moins un ensemble de données de trafic de l'au moins une autre région géographique, l'analyse (S26) d'un flux de mobilité de la zone géographique pour déterminer au moins une corrélation entre les données de trafic de la région géographique cible et les données de trafic de l'au moins une autre région géographique ; et

    la génération (S28) d'une prévision de trafic combinée en ajustant la prévision saisonnière pour la région géographique cible sur la base de l'au moins une autre prévision saisonnière et de l'au moins une corrélation déterminée ; et

    la prédiction (S101) d'émissions produites par le trafic dans la région géographique cible sur la base de la prévision de trafic combinée,

    dans lequel les données de trafic comprennent des données obtenues à partir de capteurs dans la région géographique concernée,

    dans lequel les données de trafic de ladite région géographique comprennent :

    un certain nombre de véhicules à l'intérieur de la région géographique ou un certain nombre de chacun d'une pluralité de types de véhicules à l'intérieur de la région géographique ; et

    une vitesse moyenne de chacun d'une pluralité de véhicules à l'intérieur de la région géographique,

    dans lequel la réalisation de l'analyse de mobilité sur la base dudit ensemble représentatif de données de trafic pour déterminer les paramètres comprend :

l'obtention de niveaux de stationnarité d'une tendance annuelle dans ledit ensemble représentatif de données de trafic et la détermination de paramètres stationnaires ; et/ou
l'obtention de relations entre les données de différentes périodes dans ledit ensemble représentatif de données de trafic et la détermination de paramètres de régression ; et/ou
l'obtention d'une plage de valeurs dans laquelle une tendance de mobilité dans ledit ensemble représentatif de données de trafic oscille et la détermination de paramètres prédictifs,
dans lequel l'estimation (S101) des émissions comprend le calcul d'une quantité d'émissions sur la base :

d'informations indiquant les émissions moyennes d'un véhicule sur la base de la vitesse ;
du certain nombre de véhicules selon la prévision de trafic ; et
de la vitesse moyenne des véhicules selon la prévision de trafic.

2. Procédé mis en œuvre par ordinateur selon la revendication 1, dans lequel le regroupement des ensembles de données de trafic sur la base de leur similarité les uns par rapport aux autres comprend le regroupement des ensembles de données de trafic sur la base d'au moins un aspect des données de trafic, l'au moins un aspect comprenant l'un quelconque des éléments suivants :

un certain nombre de véhicules à l'intérieur de la région géographique ;
un certain nombre de chacun d'une pluralité de types de véhicules à l'intérieur de la région géographique ;
un emplacement de chacun d'une pluralité de véhicules à l'intérieur de la région géographique ;
une direction de déplacement de chacun d'une pluralité de véhicules à l'intérieur de la région géographique ;
une vitesse de chacun d'une pluralité de véhicules à l'intérieur de la région géographique ;
une vitesse moyenne de chacun d'une pluralité de véhicules à l'intérieur de la région géographique ;
une vitesse minimale et/ou maximale de chacun d'une pluralité de véhicules à l'intérieur de la région géographique ;
un niveau de congestion à l'intérieur de la région géographique ;
un certain nombre d'embouteillages à l'intérieur de la région géographique ;
un niveau d'utilisation d'un réseau routier à l'intérieur de la région géographique ; et
une capacité de transit maximale à l'intérieur de la région géographique.

3. Procédé mis en œuvre par ordinateur selon la revendication 1 ou la revendication 2, dans lequel le regroupement des ensembles de données de trafic sur la base de leur similarité les uns par rapport aux autres comprend l'utilisation d'une correspondance de déformation temporelle dynamique ou d'une correspondance euclidienne entre les ensembles de données de trafic ou entre les représentations comportementales.

4. Procédé mis en œuvre par ordinateur selon l'une quelconque des revendications précédentes, dans lequel les données de trafic comprennent des données obtenues à partir d'un jumeau numérique de la région géographique concernée.

5. Procédé mis en œuvre par ordinateur selon l'une quelconque des revendications précédentes, dans lequel la région géographique cible et l'au moins une autre région géographique sont des régions respectives d'une zone urbaine, d'une commune ou d'une ville.

6. Procédé mis en œuvre par ordinateur selon l'une quelconque des revendications précédentes, dans lequel la génération de la prévision de trafic saisonnière de la région géographique cible comprend la génération, sur la base des données de trafic concernées, de régresseurs qui définissent un aspect saisonnier des données.

7. Procédé mis en œuvre par ordinateur selon l'une quelconque des revendications précédentes, dans lequel le processus de prévision de trafic comprend l'analyse du flux de mobilité de la région géographique cible et d'une pluralité d'autres régions géographiques pour déterminer l'au moins une autre région géographique pertinente pour la prévision de trafic de la région géographique cible.

8. Procédé mis en œuvre par ordinateur selon l'une quelconque des revendications précédentes, dans lequel les données de trafic comprennent des informations concernant des événements se produisant dans la région géographique concernée, et dans lequel le processus de prévision de trafic comprend également l'analyse des données de trafic de la région cible pour obtenir au moins une corrélation entre les données de trafic et au moins un événement, et dans lequel la génération d'une prévision de trafic en ajustant la prévision saisonnière pour la région géographique cible sur la base de l'au moins une autre prévision saisonnière et de la corrélation déterminée comprend également l'ajustement de la prévision saisonnière pour la région géographique cible sur la base de l'au moins une corrélation entre les données de trafic et au moins un événement externe et sur la base d'au moins un événement prédit.

9. Procédé mis en œuvre par ordinateur selon l'une quelconque des revendications précédentes, dans lequel l'ensemble de données de trafic de la région géographique cible et l'au moins un ensemble de données de trafic pour l'au moins une autre région géographique comprennent des données de trafic sur une première période et la prévision de trafic combinée est une première prévision de trafic,

dans lequel le procédé mis en œuvre par ordinateur comprend également la génération d'une seconde prévision de trafic en réalisant le processus de prévision de trafic à l'aide de données de trafic sur une seconde période, dans lequel la première période comprend la seconde période et une période supplémentaire plus récente que la seconde période, dans lequel le procédé mis en œuvre par ordinateur comprend :

la décomposition de la première prévision de trafic en premières composantes saisonnières, de tendance et de bruit, et la décomposition de la seconde prévision de trafic en secondes composantes saisonnières, de tendance et de bruit ; et

la comparaison de la première composante de bruit de la première prévision de trafic avec la seconde composante de bruit de la seconde prévision de trafic pour détecter au moins une anomalie, comprenant la comparaison d'au moins un écart entre les première et seconde prévisions de trafic à un seuil d'anomalie, et dans lequel la prédiction d'émissions produites par le trafic dans la région géographique cible comporte, lorsqu'au moins une anomalie a été détectée, la prédiction de l'impact sur les émissions de l'au moins une anomalie détectée.

10. Procédé mis en œuvre par ordinateur comprenant la réalisation du procédé mis en œuvre par ordinateur selon l'une quelconque des revendications précédentes une pluralité de fois avec une région géographique différente de la zone géographique en tant que région cible à chaque fois.

11. Programme informatique qui, lorsqu'il est exécuté sur un ordinateur, amène l'ordinateur à effectuer un procédé comprenant :
sur la base d'une pluralité d'ensembles de données de trafic d'une pluralité de régions géographiques, respectivement, la réalisation d'un processus de détermination de paramètre comprenant :

le regroupement (S212) des ensembles de données de trafic sur la base de leur similarité les uns par rapport aux autres pour générer une pluralité de groupes des ensembles de données de trafic ;

pour chaque groupe comprenant une pluralité d'ensembles de données de trafic, la sélection (S214) en tant qu'ensemble représentatif de données de trafic de l'ensemble de données de trafic du groupe qui est le plus similaire à une moyenne des ensembles de données de trafic du groupe ; et

sur la base d'un ensemble représentatif de données de trafic correspondant à une région géographique cible, la réalisation (S216) d'une analyse de mobilité pour déterminer les paramètres pour une prévision de trafic saisonnière pour la région géographique cible et, sur la base d'au moins un ensemble représentatif de données de trafic correspondant à au moins une autre région géographique, la réalisation d'une analyse de mobilité pour déterminer les paramètres pour au moins une autre prévision de trafic saisonnière pour l'au moins une autre région géographique ;

la réalisation d'un processus de prévision de trafic pour la région géographique cible à l'aide de l'ensemble de données de trafic de la région géographique cible et de l'au moins un ensemble de données de trafic pour l'au moins une autre région géographique, le processus de prévision de trafic comprenant :

sur la base de l'ensemble de données de trafic de la région géographique cible, et à l'aide des paramètres déterminés pour la prévision de trafic saisonnière pour la région géographique cible, la génération (S22) de la prévision de trafic saisonnière pour la région géographique cible ;

sur la base de l'au moins un ensemble de données de trafic de l'au moins une autre région géographique, et à l'aide des paramètres déterminés pour l'au moins une autre prévision de trafic saisonnière pour l'au moins une autre région géographique, la génération (S24) de l'au moins une autre prévision de trafic saisonnière pour l'au moins une autre région géographique ;

sur la base de l'ensemble de données de trafic de la région géographique et de l'au moins un ensemble de données de trafic de l'au moins une autre région géographique, l'analyse (S26) d'un flux de mobilité de la zone géographique pour déterminer au moins une corrélation entre les données de trafic de la région géographique cible et les données de trafic de l'au moins une autre région géographique ; et

la génération (S28) d'une prévision de trafic combinée en ajustant la prévision saisonnière pour la région géographique cible sur la base de l'au moins une autre prévision saisonnière et de l'au moins une corrélation déterminée ; et

la prédiction (S101) d'émissions produites par le trafic dans la région géographique cible sur la base de la prévision de trafic combinée,

dans lequel les données de trafic comprennent des données obtenues à partir de capteurs dans la région géographique concernée,

dans lequel les données de trafic de ladite région géographique comprennent :

un certain nombre de véhicules à l'intérieur de la région géographique ou un certain nombre de chacun d'une pluralité de types de véhicules à l'intérieur de la région géographique ; et

une vitesse moyenne de chacun d'une pluralité de véhicules à l'intérieur de la région géographique, dans lequel la réalisation de l'analyse de mobilité sur la base dudit ensemble représentatif de données de trafic pour déterminer les paramètres comprend :

l'obtention de niveaux de stationnarité d'une tendance annuelle dans ledit ensemble représentatif de données de trafic et la détermination de paramètres stationnaires ; et/ou

l'obtention de relations entre les données de différentes périodes dans ledit ensemble représentatif de données de trafic et la détermination de paramètres de régression ; et/ou

l'obtention d'une plage de valeurs dans laquelle une tendance de mobilité dans ledit ensemble représentatif de données de trafic oscille et la détermination de paramètres prédictifs,

dans lequel l'estimation (S101) des émissions comprend le calcul d'une quantité d'émissions sur la base :

d'informations indiquant les émissions moyennes d'un véhicule sur la base de la vitesse ;
du certain nombre de véhicules selon la prévision de trafic ; et
de la vitesse moyenne des véhicules selon la prévision de trafic.

12. Appareil de traitement d'informations (900) comprenant une mémoire (994) et un processeur (993) connecté à la mémoire (994), dans lequel le processeur (993) est configuré pour :

sur la base d'une pluralité d'ensembles de données de trafic d'une pluralité de régions géographiques, respectivement, réaliser un processus de détermination de paramètre comprenant :

le regroupement des ensembles de données de trafic sur la base de leur similarité les uns par rapport aux autres pour générer une pluralité de groupes des ensembles de données de trafic ;

pour chaque groupe comprenant une pluralité d'ensembles de données de trafic, la sélection en tant qu'ensemble représentatif de données de trafic de l'ensemble de données de trafic du groupe qui est le plus similaire à une moyenne des ensembles de données de trafic du groupe ; et

sur la base d'un ensemble représentatif de données de trafic correspondant à une région géographique cible, la réalisation d'une analyse de mobilité pour déterminer les paramètres pour une prévision de trafic saisonnière pour la région géographique cible et, sur la base d'au moins un ensemble représentatif de données de trafic correspondant à au moins une autre région géographique, la réalisation d'une analyse de mobilité pour déterminer les paramètres pour au moins une autre prévision de trafic saisonnière pour l'au moins une autre région géographique ;

réaliser un processus de prévision de trafic pour la région géographique cible à l'aide de l'ensemble de données de trafic de la région géographique cible et de l'au moins un ensemble de données de trafic pour l'au moins une autre région géographique, le processus de prévision de trafic comprenant :

sur la base de l'ensemble de données de trafic de la région géographique cible, et à l'aide des paramètres déterminés pour la prévision de trafic saisonnière pour la région géographique cible, la génération de la prévision de trafic saisonnière pour la région géographique cible ;

sur la base de l'au moins un ensemble de données de trafic de l'au moins une autre région géographique, et à l'aide des paramètres déterminés pour l'au moins une autre prévision de trafic saisonnière pour l'au moins une autre région géographique, la génération de l'au moins une autre prévision de trafic saisonnière pour l'au moins une autre région géographique ;

sur la base de l'ensemble de données de trafic de la région géographique et de l'au moins un ensemble de données de trafic de l'au moins une autre région géographique, l'analyse d'un flux de mobilité de la zone géographique pour déterminer au moins une corrélation entre les données de trafic de la région géographique cible et les données de trafic de l'au moins une autre région géographique ; et

la génération d'une prévision de trafic combinée en ajustant la prévision saisonnière pour la région géographique cible sur la base de l'au moins une autre prévision saisonnière et de l'au moins une corrélation déterminée ; et

prédire les émissions produites par le trafic dans la région géographique cible sur la base de la prévision de trafic combinée,

dans lequel les données de trafic comprennent des données obtenues à partir de capteurs dans la région géographique concernée,

dans lequel les données de trafic de ladite région géographique comprennent :

un certain nombre de véhicules à l'intérieur de la région géographique ou un certain nombre de chacun d'une pluralité de types de véhicules à l'intérieur de la région géographique ; et

une vitesse moyenne de chacun d'une pluralité de véhicules à l'intérieur de la région géographique, dans lequel la réalisation de l'analyse de mobilité sur la base dudit ensemble représentatif de données de trafic pour déterminer les paramètres comprend :

l'obtention de niveaux de stationnarité d'une tendance annuelle dans ledit ensemble représentatif de données de trafic et la détermination de paramètres stationnaires ; et/ou

l'obtention de relations entre les données de différentes périodes dans ledit ensemble représentatif de données de trafic et la détermination de paramètres de régression ; et/ou

l'obtention d'une plage de valeurs dans laquelle une tendance de mobilité dans ledit ensemble représentatif de données de trafic oscille et la détermination de paramètres prédictifs,

dans lequel l'estimation des émissions comprend le calcul d'une quantité d'émissions sur la base :

d'informations indiquant les émissions moyennes d'un véhicule sur la base de la vitesse ;

du certain nombre de véhicules selon la prévision de trafic ; et

de la vitesse moyenne des véhicules selon la prévision de trafic.

FIGURE 1

EP 4 478 325 B1

FIGURE 2

FIGURE 3

FIGURE 4

EP 4 478 325 B1

| S20 | Traffic forecasting process with respect to first time period |

| S40 | Traffic forecasting process with respect to second time period |

| S60 | Decompose into seasonal, trend, and noise components |

| S80 | Compare noise components to detect at least one anomaly |

| S100 | Estimate emissions |

FIGURE 5

EP 4 478 325 B1

S22 | Generate seasonal traffic forecast for target region

↓

S24 | Generate seasonal traffic forecast for at least one other region

↓

S26 | Analyze mobility flow of target region and at least one other region to determine correlation

↓

S28 | Adjust seasonal traffic forecast for target region based on other forecast and correlation

S101
- - -> Estimate emissions

FIGURE 6

FIGURE 7

EP 4 478 325 B1

A

```
date        interval    traceid                 time       speed
2021-01-01  03:00       8SV78h5T52tMByqYyDFQ     03:08:44   52
                                                 03:08:54   53
                                                 03:09:04   47
                                                 03:09:14   45
                                                 03:09:24   14

2021-12-31  20:45       3K4auvmTQOQ2JJIucGbiw    20:48:44   40
                                                 20:48:54   32
                                                 20:49:04   42
                                                 20:49:14   46
            23:00       ejuEbBaKT1i7dVZptvi1rA   23:14:45   48
```

C

```
(1, 1, 1)x(2, 0, [1, 2], 12)
```

B

| | traceid | latitude | longitude | heading | speed | weekday | date | month | time | hour | Square_ID | interval |
|---|---|---|---|---|---|---|---|---|---|---|---|---|
| 0 | 4NDew2AgTEWXLxQksNlIQ | 50.761118 | -1.296039 | 269.0 | 5 | Wednesday | 2020-01-01 | 1 | 00:59:07 | 0 | Sq532 | 00:45 |
| 1 | 4NDew2AgTEWXLxQksNlIQ | 50.760650 | -1.297041 | 231.0 | 0 | Wednesday | 2020-01-01 | 1 | 01:01:27 | 1 | Sq532 | 01:00 |
| 2 | 4NDew2AgTEWXLxQksNlIQ | 50.758886 | -1.297330 | 234.0 | 31 | Wednesday | 2020-01-01 | 1 | 01:02:57 | 1 | Sq532 | 01:00 |
| 3 | 4NDew2AgTEWXLxQksNlIQ | 50.751585 | -1.299707 | 255.0 | 36 | Wednesday | 2020-01-01 | 1 | 01:04:27 | 1 | Sq506 | 01:00 |
| 4 | 4NDew2AgTEWXLxQksNlIQ | 50.744554 | -1.307137 | 201.0 | 45 | Wednesday | 2020-01-01 | 1 | 01:05:57 | 1 | Sq481 | 01:00 |

FIGURE 8

FIGURE 9

EP 4 478 325 B1

A

| | traceid | latitude | longitude | heading | speed | weekday | date | month | time | hour | Square_ID | interval |
|---|---|---|---|---|---|---|---|---|---|---|---|---|
| 0 | 4NDew2AgTEWXLxQksNlIQ | 50.761118 | -1.296039 | 269.0 | 5 | Wednesday | 2020-01-01 | 1 | 00:59:07 | 0 | Sq532 | 00:45 |
| 1 | 4NDew2AgTEWXLxQksNlIQ | 50.760650 | -1.297041 | 231.0 | 0 | Wednesday | 2020-01-01 | 1 | 01:01:27 | 1 | Sq532 | 01:00 |
| 2 | 4NDew2AgTEWXLxQksNlIQ | 50.758886 | -1.297330 | 234.0 | 31 | Wednesday | 2020-01-01 | 1 | 01:02:57 | 1 | Sq532 | 01:00 |
| 3 | 4NDew2AgTEWXLxQksNlIQ | 50.751585 | -1.299707 | 255.0 | 36 | Wednesday | 2020-01-01 | 1 | 01:04:27 | 1 | Sq506 | 01:00 |
| 4 | 4NDew2AgTEWXLxQksNlIQ | 50.744554 | -1.307137 | 201.0 | 45 | Wednesday | 2020-01-01 | 1 | 01:05:57 | 1 | Sq481 | 01:00 |

B

"BH21 6AS","BH21 6AS","198001","199112","4108","
"BH23 5QQ","BH23 5QQ","198001","","4222","00947"
"BH23 7AG","BH23 7AG","198001","","4179","00971"
"BH23 7AH","BH23 7AH","198001","","4180","00971"
"BH23 7AJ","BH23 7AJ","198001","","4179","00973"

C

oid,departure_step,timestamp,origin_lon,origin_lat,origin_taz,origin_sumo_taz,dest_lon,dest_lat,dest_taz,dest_sumo_taz,household_car
person-0,1,05:00:01,-1.295001468376144,50.7093483,42,42,-1.2874810652429416,50.70690696783305,94,94,4,1,1,4.691153010195025,5.35809169463447
person-1,6,05:00:06,-1.2354610186787705,50.73251326364236,202,202,-1.2333057,50.7233383,363,363,2,1,1,4.691153010195025,5.358091694634474,-0
person-2,8,05:00:08,-1.1533307,50.7232423,195,195,-1.155260851956611,50.726932692984995,371,371,1,2,1,4.691153010195025,5.358091694634474,-0
person-3,9,05:00:09,-1.2862793304679605,50.67074625892454,121,121,-1.2314575874164517,50.6714796239963,282,282,1,1,1,4.691153010195025,5.3580

FIGURE 10

A

{"events": [{"event_id":364108,"modified_ts":"2023-01-15T02:29:33Z","created_ts":"2013-08-13T12:57:24Z","name":"Voodoo Room: A Night of {"event_id":1872328,"modified_ts":"2022-09-15T01:24:34Z","created_ts":"2022-05-16T02:13:25Z","name":"Iwjw22 [D] Liane Carroll Trio","sort_name" {"event_id":1872851,"modified_ts":"2022-08-06T01:29:40Z","created_ts":"2022-05-17T02:14:11Z","name":"Iwjw22 [J] Hexagonal","sort_name":"Iwjw22 {"event_id":1879912,"modified_ts":"2022-11-08T17:15:23Z","created_ts":"2022-11-08T17:15:23Z","name":"Marcel Lucont: Le \u201cBest Of\u201d","so

B

| date | sin365 | cos365 | sin365_2 | cos365_2 |
|---|---|---|---|---|
| 2021-01-01 00:00:00 | 0.017202 | 0.999852 | 0.034398 | 0.999408 |
| 2021-01-01 00:15:00 | 0.017202 | 0.999852 | 0.034398 | 0.999408 |
| 2021-01-01 00:30:00 | 0.017202 | 0.999852 | 0.034398 | 0.999408 |
| 2021-01-01 00:45:00 | 0.017202 | 0.999852 | 0.034398 | 0.999408 |
| 2021-01-01 01:00:00 | 0.017202 | 0.999852 | 0.034398 | 0.999408 |

C

| | forecast |
|---|---|
| 2022-01-01 00:00:00 | 0.604739 |
| 2022-01-01 00:05:00 | 0.604186 |
| 2022-01-01 00:10:00 | 0.603498 |
| 2022-01-01 00:15:00 | 0.602747 |
| 2022-01-01 00:20:00 | 0.602049 |

FIGURE 11

44

FIGURE 12

FIGURE 13

FIGURE 14

A

| | traceid | latitude | longitude | heading | speed | weekday | date | month | time | hour | Square_ID | interval |
|---|---|---|---|---|---|---|---|---|---|---|---|---|
| 0 | 4NDew2AgTEWXLxQksNlIQ | 50.761118 | -1.296039 | 269.0 | 5 | Wednesday | 2020-01-01 | 1 | 00:59:07 | 0 | Sq532 | 00:45 |
| 1 | 4NDew2AgTEWXLxQksNlIQ | 50.760650 | -1.297041 | 231.0 | 0 | Wednesday | 2020-01-01 | 1 | 01:01:27 | 1 | Sq532 | 01:00 |
| 2 | 4NDew2AgTEWXLxQksNlIQ | 50.758886 | -1.297330 | 234.0 | 31 | Wednesday | 2020-01-01 | 1 | 01:02:57 | 1 | Sq532 | 01:00 |
| 3 | 4NDew2AgTEWXLxQksNlIQ | 50.751585 | -1.299707 | 255.0 | 36 | Wednesday | 2020-01-01 | 1 | 01:04:27 | 1 | Sq506 | 01:00 |
| 4 | 4NDew2AgTEWXLxQksNlIQ | 50.744554 | -1.307137 | 201.0 | 45 | Wednesday | 2020-01-01 | 1 | 01:05:57 | 1 | Sq481 | 01:00 |

B

| | forecast |
|---|---|
| 2022-01-01 00:00:00 | 0.604739 |
| 2022-01-01 00:05:00 | 0.604186 |
| 2022-01-01 00:10:00 | 0.603498 |
| 2022-01-01 00:15:00 | 0.602747 |
| 2022-01-01 00:20:00 | 0.602049 |

FIGURE 15

```
{
  "identifier": "AS_101_2022-12-08 17:51:54",
  "timestamp": "2023-05-24 11:45:34",
  "cell": "101",
  "sourceType": "traffic",
  "valueType": "averageSpeed",
  "status": "data-available",
  "actual": [
    {
      "time": 1670457600,
      "value": 0
    },
    {
      "time": 1670458500,
      "value": 0
    },
    {
      "time": 1670459400,
      "value": 0
    }
  ],
  "forecast": [
    {
      "time": 1670523300,
      "value": 90.34403319011119
    },
    {
      "time": 1670524200,
      "value": 90.33951551849844
    },
    {
      "time": 1670525100,
      "value": 90.33250505295588
    },
    {
      "time": 1670526000,
      "value": 90.32297654893505
    },
    {
      "time": 1670543100,
      "value": 87.0184454820501
    },
    {
      "time": 1670543100,
      "value": 86.69110197813662
    },
    {
      "time": 1670543100,
      "value": 86.36101441974635
    }
  ],
  "anomalies": []
}
```

FIGURE 16

FIGURE 17

FIGURE 18

EP 4 478 325 B1

FIGURE 19

EP 4 478 325 B1

FIGURE 20

S212 | Cluster sets of traffic data

S214 | For each cluster, select a representative set of traffic data

S216 | Based on representative set, perform mobility analysis to generate optimal parameters

FIGURE 21

FIGURE 22

EP 4 478 325 B1

Dynamic Time Warping Matching

Euclidean Matching

FIGURE 23

FIGURE 24

FIGURE 25

900

```
┌─────────────────┐        ┌─────────────────┐
│ PROCESSOR       │        │ MEMORY          │
│                 │        │                 │
│            993  │        │            994  │
└────────┬────────┘        └────────┬────────┘
         │                          │
─────────┼──────────────────────────┼─────────────── 992
─────────┼──────┬───────────────────┼──────────┬─────
         │      │                   │          │
┌────────┴──────┴─┐  ┌──────────────┴──┐  ┌────┴────────────┐
│            995  │  │            996  │  │            997  │
│                 │  │                 │  │                 │
│ DISPLAY         │  │ INPUT           │  │ NETWORK I/F     │
└─────────────────┘  └─────────────────┘  └─────────────────┘
```

FIGURE 26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KUMAR, S.V.** ; **VANAJAKSHI, L.** Short-term traffic flow prediction using seasonal ARIMA model with limited input data. *Eur. Transp. Res. Rev.*, 2015, vol. 7, 21, https://doi.org/10.1007/s12544-015-0170-8
- **MAI T** ; **GHOSH B** ; **WILSON S**. Multivariate short-term traffic flow forecasting using Bayesian vector autoregressive moving average model. *Proceedings of the 91st Transportation Research Board Annual Meeting, Washington, D.C*, 2012
- **GHOSH B** ; **BASU B** ; **MAHONY MO**. Bayesian time-series model for short-term traffic flow forecasting. *J Transp Eng*, 2007, vol. 133 (3), 180-189

- **WILLIAMS BM** ; **HOEL LA**. Modeling and forecasting vehicular traffic flow as a seasonal ARIMA process: theoretical basis and empirical results. *J Transp Eng*, 2003, vol. 129 (6), 664-672
- **GHOSH B** ; **BASU B** ; **MAHONY MO**. Time-series modelling for forecasting vehicular traffic flow in Dublin. *Proceedings of the 85th Transportation Research Board Annual Meeting, Washington, D.C*, 2005
- **LIPPI M** ; **BERTINI M** ; **FRASCONI P**. Short-term traffic flow forecasting: an experimental comparison of time-series analysis and supervised learning. *IEEE Trans intell Transp Syst*, 2013, vol. 14 (2), 871-882